# EUROPEAN PATENT APPLICATION

(11) **EP 4 852 057 A1**
(43) Date of publication of application: **09.12.2026**
(21) Application number: 24922403.1
(22) Date of filing: 19.11.2024
(51) Int. Cl.: H01L 25/075, H10H 29/01, H10H 20/857, H10D 86/00

(54) **DISPLAY DEVICE**

(30) Priority: 01.02.2024 KR 20240016208
(71) Applicant: Samsung Display Co., Ltd., Yongin-si, Gyeonggi-do 17113 (KR)
(72) Inventor: KIM, Yeon Kyung, Yongin-si, Gyeonggi-do 17113 (KR); HONG, Sung Chul, Yongin-si, Gyeonggi-do 17113 (KR); PARK, Do Yeong, Yongin-si, Gyeonggi-do 17113 (KR)
(74) Representative: Marks & Clerk LLP
(86) International application number: PCT/KR2024/018223
(87) International publication number: WO 2025/164894

(57) **Abstract**

A display device includes a display element layer, the display element layer includes an anode electrode and a cathode electrode, disposed on a substrate and spaced apart from each other in a first direction, an overcoat pattern partially covering the anode electrode and the cathode electrode, a light emitting element disposed on the overcoat pattern and including a first element electrode and a second element electrode, an anode transparent electrode disposed on the overcoat pattern to electrically connect the first element electrode and the anode electrode, and a cathode transparent electrode disposed on the overcoat pattern to electrically connect the second element electrode and the cathode electrode, the cathode transparent electrode includes a line electrode extending in a second direction, and a branch electrode extending in the first direction from the line electrode, the first element electrode and the second element electrode are spaced apart from each other at a first distance in the first direction, and the anode transparent electrode and the branch electrode are spaced apart from each other at a second distance greater than or equal to the first distance in the first direction.

## Description

### Technical Field

This disclosure relates to a display device.

### Background Art

With the development of multimedia, the importance of display devices has increased. Accordingly, display devices such as liquid crystal display devices, organic light emitting display devices, and inorganic light emitting devices are increasingly used. In particular, studies on micro LEDs which have a high response speed and can implement a high luminance as compared with the existing LEDs have been actively conducted.

Recently, as display devices are gradually miniaturized, the size of a pixel (or sub-pixel) and the distance between pixels (or sub-pixels) have been gradually decreased in a display device (or display panel). Accordingly, a method capable of preventing a short circuit caused by residues generated in processes of the display device may be desired.

The above information is only for enhancement of understanding of the background of the disclosure and therefore it may contain information that does not form the prior art to a person of ordinary skill in the art.

### Detailed Description of Invention

### Technical Problem

Embodiments of present invention provide a pixel and a display device including the same, which have improved reliability. For example, the display device prevents a short circuit caused by residues, thereby reducing a failure risk.

### Technical Solution

A display device according to an embodiment of the present invention includes a display element layer disposed on a substrate, wherein the display element layer includes; an anode electrode and a cathode electrode, disposed on the substrate and spaced apart from each other in a first direction; an overcoat pattern partially covering the anode electrode and the cathode electrode; a light emitting element disposed on the overcoat pattern, the light emitting element including a first element electrode and a second element electrode, wherein the first element electrode and the second element electrode are adjacent to the anode electrode and the cathode electrode, respectively; an anode transparent electrode disposed on the overcoat pattern to electrically connect the first element electrode and the anode electrode to each other; and a cathode transparent electrode disposed on the overcoat pattern to electrically connect the second element electrode and the cathode electrode to each other, wherein the cathode transparent electrode includes a line electrode extending in a second direction intersecting the first direction, and a branch electrode extending in the first direction from the line electrode, the first element electrode and the second element electrode are spaced apart from each other at a first distance in the first direction, and the anode transparent electrode and the branch electrode are spaced apart from each other at a second distance greater than or equal to the first distance in the first direction.

The branch electrode may overlap the overcoat pattern in plan view, and the line electrode may not overlap the overcoat pattern in plan view.

A circumference of the overcoat pattern may include a first edge overlapping the anode transparent electrode in plan view, a second edge overlapping the branch electrode in plan view, a third edge extending between the first edge and the second edge, and a fourth edge extending between the first edge and the second edge, the fourth edge being opposite to the third edge. At least one of the third edge and the fourth edge may have a length longer than the first distance.

The display element layer may further include a residue pattern disposed adjacent to at least one of the third edge and the fourth edge.

The residue pattern may have a length longer than the first distance.

The overcoat pattern may include a first portion, a second portion, and a third portion, which are sequentially disposed in the second direction. Each of the first to third portions may extend in the first direction to overlap the anode electrode and the cathode electrode in plan view. The first portion may overlap the anode transparent electrode in plan view without overlapping the branch electrode in plan view. The second portion may overlap both the branch electrode and the anode transparent electrode in plan view. The third portion may overlap the branch electrode in plan view without overlapping the anode transparent electrode in plan view.

The first element electrode and the second element electrode may be spaced apart from each other in the first direction. The anode transparent electrode may overlap at least a portion of the first element electrode in plan view. The cathode transparent electrode may overlap at least a portion of the second element electrode in plan view.

The anode transparent electrode may overlap about 1/3 or more of an area of the first element electrode in a plan view.

The anode electrode may have a first width in the second direction. The anode transparent electrode may have a second width in the second direction. The second width may be narrower than the first width.

The anode transparent electrode may include a first portion and a second portion. The first portion may extend in the first direction. The second portion may extend in a diagonal direction intersecting the first and second directions from the first portion to overlap a portion of the first element electrode.

The cathode transparent electrode may overlap about 1/3 or more of an area of the second element electrode in a plan view.

The line electrode may be spaced apart from the overcoat pattern in the first direction.

The branch electrode may include a first portion and a second portion. The first portion may extend in the first direction. The second portion may extend in a diagonal direction intersecting the first and second directions from the first portion to overlap at least a portion of the second element electrode.

The anode transparent electrode and the cathode transparent electrode may be disposed in a same layer. The anode transparent electrode and the cathode transparent electrode may include a same transparent conductive material.

A display device according to another embodiment of the present invention includes a display element layer disposed on a substrate, wherein the display element layer includes: anode electrodes disposed on the substrate; a cathode electrode disposed on the substrate, the cathode electrode being spaced apart from the anode electrodes in a first direction; overcoat patterns partially covering the anode electrodes and the cathode electrode; light emitting elements disposed on the overcoat patterns, the light emitting elements each including a first element electrode and a second element electrode; anode transparent electrodes disposed on the overcoat patterns to electrically connect the first element electrodes of the light emitting elements to the anode electrodes; and a cathode transparent electrode disposed on the overcoat patterns to electrically connect the second element electrodes of the light emitting elements to the cathode electrode, the cathode transparent electrode includes a line electrode extending in a second direction intersecting the first direction, and branch electrodes extending in the first direction from the line electrode, the first element electrode and the second element electrode of any one of the light emitting elements are spaced apart from each other at a first distance in the first direction, and any one of the anode transparent electrodes and any one of the branch electrodes are spaced apart from each other at a second distance greater than or equal to the first distance in the first direction.

The light emitting elements may include a first light emitting element and a second light emitting element, the anode electrodes may include a first anode electrode and a second anode electrode, the anode transparent electrodes may include a first anode transparent electrode electrically connecting the first element electrode of the first light emitting element to the first anode electrode and a second anode transparent electrode electrically connecting the first element electrode of the second light emitting element to the second anode electrode, the first anode transparent electrode and the second anode transparent electrode may be spaced apart from each other at a third distance in the second direction, and the first anode electrode and the second anode electrode may be spaced apart from each other at a fourth distance smaller than the third distance in the second direction.

Each of the first element electrodes of the first and second light emitting elements may have a first width in the second direction. The third distance may be smaller than or equal to a sum of about a half of the first width and the fourth distance.

The branch electrodes may overlap the overcoat patterns in plan view. The line electrode may not overlap the overcoat patterns in plan view.

A circumference of any one of the overcoat patterns may include a first edge overlapping a corresponding one of the anode transparent electrodes in plan view, a second edge overlapping a corresponding one of the branch electrodes in plan view, a third edge extending between the first edge and the second edge, and a fourth edge extending between the first edge and the second edge, the fourth edge being opposite to the third edge. At least one of the third edge and the fourth edge may have a length longer than the first distance.

The display element layer may further include a residue pattern disposed adjacent to at least one of the third edge and the fourth edge of the any one of the overcoat patterns.

### Advantageous Effects

In accordance with the disclosure, there can be provided a display device having improved reliability.

Effects according to embodiments are not limited by the contents exemplified above, and more various effects are included in this specification.

### Description of Drawings

FIG. 1 is a block diagram illustrating an embodiment of a display device.
FIG. 2 is a block diagram illustrating an embodiment of any one of sub-pixels shown in FIG. 1.
FIG. 3 is a plan view illustrating an embodiment of a display panel shown in FIG. 1.
FIG. 4 is a cross-sectional view illustrating an embodiment of the display panel shown in FIG. 3.
FIG. 5 is a cross-sectional view illustrating an embodiment of the display panel shown in FIG. 3.
FIG. 6 is a plan view illustrating an embodiment of any one of pixels shown in FIG. 3.
FIG. 7 is an enlarged view illustrating portion A shown in FIG. 6.
FIG. 8 is a cross-sectional view taken along line I-I' shown in FIG. 6.
FIGS. 9 to 11 are plan views illustrating other embodiments of any one of pixels shown in FIG. 1.
FIG. 12 is a flowchart illustrating an embodiment of a method of manufacturing the display device shown in FIG. 1.
FIG. 13 is a plan view of the display device of an operation shown in FIG. 12.
FIG. 14 is a cross-sectional view taken along line I-I' shown in FIG. 13.
FIG. 15 is a plan view of the display device of an operation shown in FIG. 12.
FIG. 16 is a cross-sectional view taken along line I-I' shown in FIG. 15.
FIG. 17 is a plan view of the display device of an operation shown in FIG. 12.
FIG. 18 is a cross-sectional view taken along line I-I' shown in FIG. 17.
FIG. 19 is a plan view of the display device of an operation shown in FIG. 12.
FIG. 20 is a cross-sectional view taken along line I-I' shown in FIG. 19.
FIG. 21 is a block diagram illustrating an embodiment of a display system.
FIGS. 22 to 25 are perspective views illustrating application examples of the display system shown in FIG. 21.

### Modes of the Invention

Hereinafter, embodiments of the present disclosure will be described in more detail with reference to the accompanying drawings. In the description below, only a necessary part to understand an operation according to the present disclosure is described and the descriptions of other parts are omitted in order not to unnecessarily obscure subject matters of the present disclosure. In addition, the present disclosure is not limited to embodiments described herein, but may be embodied in various different forms. Rather, embodiments described herein are provided to thoroughly and completely describe the disclosed contents and to sufficiently transfer the ideas of the disclosure to a person of ordinary skill in the art.

In the entire specification, when an element is referred to as being "connected" to another element, it can be "directly connected" to the another element or be "indirectly connected" to the another element with one or more intervening elements interposed therebetween. The technical terms used herein are used only for the purpose of illustrating a specific embodiment and not intended to limit the embodiment. It will be understood that when a component "includes" an element, unless there is another opposite description thereto, it should be understood that the component does not exclude another element but may further include another element. It will be understood that for the purposes of this disclosure, "at least one of X, Y, and Z" can be construed as X only, Y only, Z only, or any combination of two or more items X, Y, and Z (e.g., XYZ, XYY, YZ, ZZ). Similarly, for the purposes of this disclosure, "at least one selected from the group consisting of X, Y, and Z" can be construed as X only, Y only, Z only, or any combination of two or more items X, Y, and Z (e.g., XYZ, XYY, YZ, ZZ). Herein, "and/or" includes any one or all combinations of the corresponding elements.

It will be understood that, although the terms first, second, etc. may be used herein to describe various elements, these elements should not be limited by these terms. These terms are only used to distinguish one element from another element. Thus, a "first" element discussed below could also be termed a "second" element without departing from the teachings of the present disclosure.

Spatially relative terms such as "below" and "above" may be used for purposes of description, and thereby describe a relationship of one element or feature to another element(s) or feature(s) as illustrated in the drawings. It will be understood that the spatially relative terms, as well as the illustrated configurations, are intended to encompass different orientations of the apparatus in use or operation in addition to the orientations described herein and depicted in the figures. For example, if the apparatus in the figures is turned over, elements described as "below" other elements or features would then be oriented "above" the other elements or features. Thus, the example term, "below," may encompass both an orientation of above and below. The apparatus may be otherwise oriented (e.g., rotated 90 degrees or at other orientations) and the spatially relative descriptors used herein interpreted accordingly.

Various embodiments are described with reference to drawings that schematically illustrate ideal embodiments. Accordingly, it will be expected that the shapes may vary, for example, depending on tolerances and/or manufacturing techniques. Therefore, the embodiments disclosed herein should not be construed as being limited to the specific shapes shown, and should be construed as including, for example, variations in shapes that occur as a result of manufacturing. As such, the shapes shown in the drawings may not represent the actual shapes of regions of a device, and the embodiments are not limited thereto.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

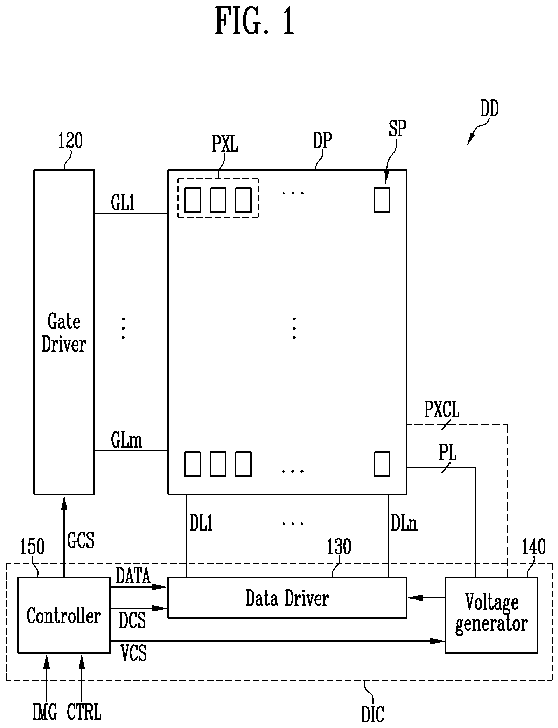

FIG. 1 is a block diagram illustrating an embodiment of a display device.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to mth gate lines GL1 to GLm. The sub-pixels SP may be connected to the data driver 130 through first to nth data lines DL1 to DLn.

The sub-pixels SP may generate lights of two or more colors. For example, each of the sub-pixels SP may generate lights of red, green, blue, cyan, magenta, yellow, white, and the like.

Two or more sub-pixels among the sub-pixels SP may constitute a pixel PXL. For example, the pixel PXL may include three sub-pixels as shown in FIG. 1. As such, the pixel PXL may emit lights of various colors with various luminances according to a combination of lights emitted from the sub-pixels included therein.

The gate driver 120 may be connected to the sub-pixels SP arranged in a row direction through the first to mth gate lines GL1 to GLm. The gate driver 120 may output gate signals to the first to mth gate lines GL1 to GLm in response to a gate control signal GCS. In embodiments, the gate control signal GCS may include a start signal indicating a start of each frame, a horizontal synchronization signal, and the like.

The gate driver 120 may be disposed at a side of the display panel DP. However, embodiments are not limited thereto. For example, the gate driver 120 may be divided into two or more drivers which are physically and/or logically divided, and these drivers may be disposed at a side of the display panel DP and another side of the display panel DP, which is opposite. As such, in some embodiments, the gate driver 120 may be disposed in various forms at the periphery of the display panel DP.

The data driver 130 may be connected to the sub-pixels SP arranged in a column direction through the first to nth data lines DL1 to DLn. The data driver 130 may receive image data DATA and a data control signal DCS from the controller 150. The data driver 130 may operate in response to the data control signal DCS. In embodiments, the data control signal DCS may include a source start pulse, a source shift clock, a source output enable signal, and the like.

The data driver 130 may receive voltages from the voltage generator 140. The data driver 130 may apply data signals having grayscale voltages corresponding to the image data DATA to the first to nth data lines DL1 to DLn by using the received voltages. In the case that a gate signal is applied to each of the first to mth gate lines GL1 to GLm, data signals corresponding to the image data DATA may be applied to the first to nth data line DL1 to DLm. Accordingly, corresponding sub-pixels SP may generate light corresponding to the data signals. Accordingly, an image may be displayed on the display panel DP.

In embodiments, the gate driver 120 and the data driver 130 may include complementary metal-oxide semiconductor (CMOS) circuit elements.

The voltage generator 140 may operate in response to a voltage control signal VCS from the controller 150. The voltage generator 140 may be configured to generate voltages and provide the generated voltages to components of the display device DD. The voltage generator 140 may generate voltages by receiving an input voltage from the outside of the display device DD and regulating the received voltage.

The voltage generator 140 may generate a first power voltage and a second power voltage. The generated first and second power voltages may be provided to the sub-pixels SP through power lines PL. In other embodiments, at least one of the first and second power voltages may be provided from the outside of the display device DD.

Further, the voltage generator 140 may provide various voltages and/or signals. For example, the voltage generator 140 may provide one or more initialization voltages applied to the sub-pixels SP. For example, in a sensing operation for sensing electrical characteristics of transistors and/or light emitting elements of the sub-pixels SP, a predetermined or selected reference voltage may be applied to the first to nth data lines DL1 to DLn, and the voltage generator 140 may generate the reference voltage and transfer the reference voltage to the data driver 130. For example, in a display operation for displaying an image on the display panel DP, common pixel control signals may be applied to the sub-pixels SP, and the voltage generator 140 may generate the pixel control signals. In embodiments, the voltage generator 140 may provide the pixel control signals to the sub-pixels SP through pixel control lines PXCL. In FIG. 1, it is illustrated that the pixel control lines PXCL are connected between the voltage generator 140 and the display panel DP. However, embodiments are not limited thereto. For example, the pixel control lines PXCL may be connected between the gate driver 120 and the display panel DP. The pixel control signals may be transferred to the pixel control lines PXCL from the voltage generator 140 through the gate driver 120.

The controller 150 may control overall operations of the display device DD. The controller 150 may receive, from the outside, input image data IMG and a control signal CTRL corresponding thereto. The controller 150 may provide the gate control signal GCS, the data control signal DCS, and the voltage control signal VCS in response to the control signal CTRL.

The controller 150 may convert the input image data IMG to be suitable for the display device DD or the display panel DP, thereby outputting the image data DATA. In embodiments, the controller 150 may align the input image data IMG to be suitable for the sub-pixels SP in units of rows, thereby outputting the image data DATA.

Two or more components among the data driver 130, the voltage generator 140, and the controller 150 may be mounted on one integrated circuit. As shown in FIG. 1, the data driver 130, the voltage generator 140, and the controller 150 may be included in a driver integrated circuit DIC. The data driver 130, the voltage generator 140, and the controller 150 may be components functionally divided in one driver integrated circuit DIC. In other embodiments, at least one of the data driver 130, the voltage generator 140, and the controller 150 may be provided as a component distinguished from the driver integrated circuit DIC.

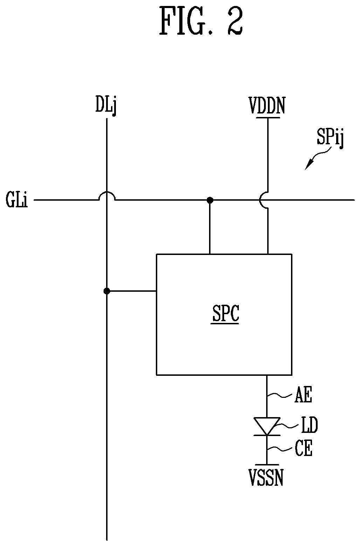

FIG. 2 is a block diagram illustrating an embodiment of any one of the sub-pixels shown in FIG. 1.

In FIG. 2, a sub-pixel SPij arranged on an ith row (i is an integer which is greater than or equal to 1 and is smaller than or equal to m) and a jth column (j is an integer which is greater than or equal to 1 and is smaller than or equal to n) among the sub-pixels SP shown in FIG. 1 is illustrated merely as an example.

Referring to FIG. 2, the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL shown in FIG. 1, to receive a first power voltage. The second power voltage node VSSN may be connected to another of the power lines PL, to receive a second power voltage. The first power voltage may have a voltage level higher than a voltage level of the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through one or more transistors included in the sub-pixel circuit SPC. The cathode electrode CE may be connected to the second power voltage node VSSN. The light emitting element LD is configured to emit light according to a current flowing from the anode electrode AE to the cathode electrode CE.

The sub-pixel circuit SPC may be connected to an ith gate line GLi among the first to mth gate lines GL1 to GLm shown in FIG. 1 and a jth data line DLj among the first to nth data lines DL1 to DLn shown in FIG. 1. In response to a gate signal received through the ith gate line GLi, the sub-pixel circuit SPC may control the light emitting element LD to emit light according to a data signal received through the jth data line DLj. In embodiments, the sub-pixel circuit SPC may be further connected to the pixel control lines PXCL shown in FIG. 1. The sub-pixel circuit SPC may control the light emitting element LD in further response to control signals received through the pixel control lines PXCL.

For these operations, the sub-pixel circuit SPC may include circuit elements, e.g., transistors and one or more capacitors.

The transistors of the sub-pixel circuit SPC may include P-type transistors and/or N-type transistors. In embodiments, the transistors of the sub-pixel circuit SPC may include a Metal Oxide Silicon Field Effect Transistor (MOSFET). In embodiments, the transistors of the sub-pixel circuit SPC may include an amorphous silicon semiconductor, a monocrystalline silicon semiconductor, polycrystalline silicon semiconductor, an oxide semiconductor, and the like.

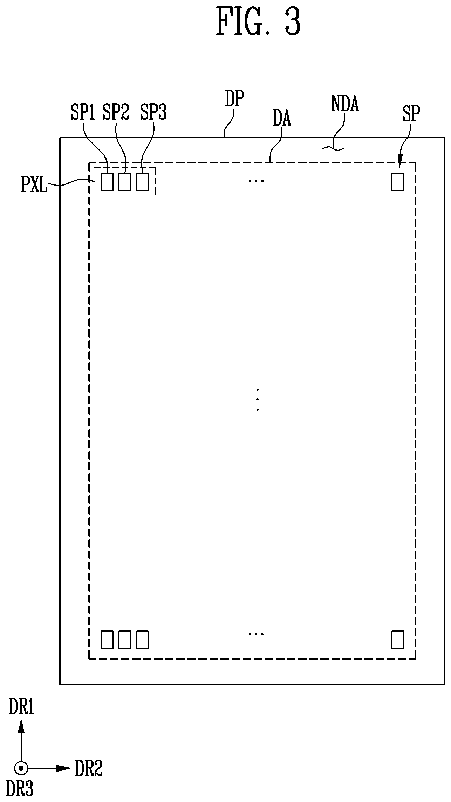

FIG. 3 is a plan view illustrating an embodiment of the display panel shown in FIG. 1.

Referring to FIG. 3, a display panel DP may include a display area DA and a non-display area NDA. The display panel DP may display an image through the display area DA. The non-display area NDA may be disposed at the periphery of the display area DA.

The display panel DP may include sub-pixels SP in the display area DA. The sub-pixels SP may be arranged in a first direction DR1 and a second direction DR2 intersecting the first direction DR1. For example, the sub-pixels SP may be arranged in a matrix form along the first direction DR1 and the second direction DR2. In another example, the sub-pixels SP may be arranged in a zigzag form along the first direction DR1 and the second direction DR2. The arrangement of the sub-pixels SP may vary in some embodiments. The first direction DR1 may be a row direction, and the second direction DR2 may be a column direction.

Two or more sub-pixels among the sub-pixels SP may constitute one pixel PXL. In FIG. 3, it is illustrated that the pixel PXL includes three sub-pixels SP1 to SP3. However, embodiments are not limited thereto. For example, the pixel PXL may include two sub-pixels. Hereinafter, for convenience of description, it is assumed that the pixel PXL includes first to third sub-pixels SP1 to SP3.

Each of the first to third sub-pixels SP1 to SP3 may generate light of one of various colors such as red, green, blue, cyan, magenta, and yellow. Hereinafter, for clear and simple description, it is assumed that the first sub-pixel SP1 is configured to generate light of a red color, the second sub-pixel SP2 is configured to generate light of a green color, and the third sub-pixel SP3 is configured to generate light of a blue color.

Each of the first to third sub-pixels SP1 to SP3 may include at least one light emitting element configured to generate light. In embodiments, light emitting elements of the first to third sub-pixels SP1 to SP3 may generate light of the same color. For example, the light emitting elements of the first to third sub-pixels SP1 to SP3 may generate light of a blue color. In other embodiments, the light emitting elements of the first to third sub-pixels SP1 to SP3 may generate lights of different colors. For example, the light emitting elements of the first to third sub-pixels SP1 to SP3 may generate lights of a red color, a green color, and a blue color, respectively.

Self-luminous display panels, such as a light emitting diode display panel (LED display panel) using a light emitting diode of micro scale or nano scale as a light emitting element and an organic light emitting display panel (OLED panel) using an organic light emitting diode as a light emitting element, may be used as the display panel DP.

A component for controlling the sub-pixels SP may be disposed in the non-display area NDA. Lines connected to the sub-pixels SP, e.g., the first to mth gate lines GL1 to GLm, the first to nth data lines DL1 to DLn, the power lines PL, and the pixel control lines PXCL, which are shown in FIG. 1, may be disposed in the non-display area NDA.

At least one of the gate driver 120, the data driver 130, the voltage generator 140, and the controller 150, which are shown in FIG. 1, may be disposed in the non-display area NDA of the display panel DP. In embodiments, the gate driver 120 may be disposed in the non-display area NDA. The data driver 130, the voltage generator 140, and the controller 150 may be implemented into the driver integrated circuit DIC shown in FIG. 1, which is distinguished from the display panel DP, and the driver integrated circuit DIC may be connected to the lines disposed in the non-display area NDA. In other embodiments, the gate driver 120, the data driver 130, the voltage generator 140, and the controller 150 may be implemented into one integrated circuit distinguished from the display panel DP.

In embodiments, the display area DA may have various shapes. The display area DA may have a closed-loop shape including linear sides and/or curved sides. For example, the display area DA may have shapes such as a polygon, a circle, a semicircle, and an ellipse.

In embodiments, the display panel DP may have a flat display surface. In other embodiments, the display panel DP may at least partially have a round display surface. In embodiments, the display panel DP may be bendable, foldable or rollable. The display panel DP and/or a substrate of the display panel DP may include materials having flexibility.

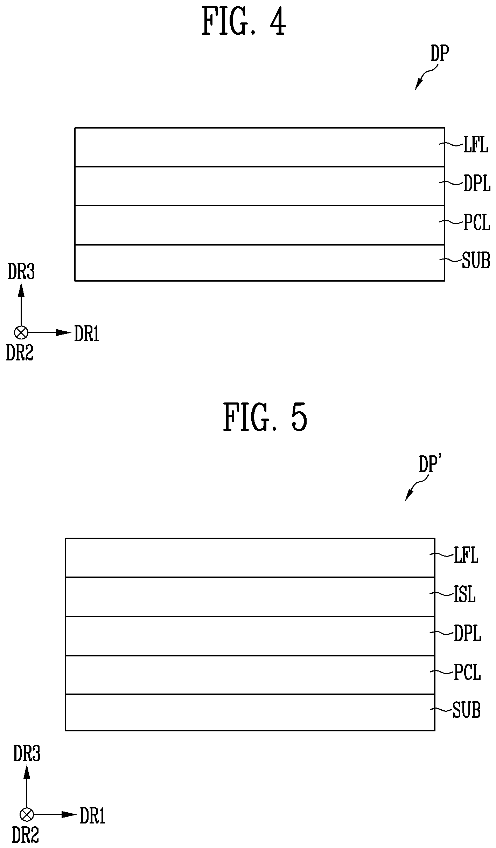

FIG. 4 is a cross-sectional view illustrating an embodiment of the display panel shown in FIG. 3.

Referring to FIG. 4, a display panel DP may include a substrate SUB, a pixel circuit layer PCL, a display element layer DPL, and a light conversion layer LFL, which are stacked on each other in a third direction DR3 intersecting the first and second directions DR1 and DR2 on the substrate SUB.

The substrate SUB may be made of an insulative material such as glass or resin. For example, the substrate SUB may include a glass substrate. In another example, the substrate SUB may include polyimide (PI) substrate. In still another example, the substrate SUB may include a silicon wafer substrate formed using a semiconductor process.

In embodiments, the substrate SUB may be made of a material having flexibility to be curvable or foldable, and have a single-layer structure or a multi-layer structure. For example, the material having flexibility may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate. However, embodiments are not limited thereto.

The pixel circuit layer PCL may be disposed on the substrate SUB. The pixel circuit layer PCL may include insulating layers, and semiconductor patterns and conductive patterns, which are disposed between the insulating layers. The conductive patterns of the pixel circuit layer PCL may serve as circuit elements, lines, and the like.

The circuit elements of the pixel circuit layer PCL may include the sub-pixel circuit SPC (see FIG. 2) of each of the sub-pixels SP shown in FIG. 3. In other words, the circuit elements of the pixel circuit layer PCL may be provided as transistors and one or more capacitors of the sub-pixel circuit SPC.

The lines of the pixel circuit layer PCL may include lines connected to each of the sub-pixels SP. The lines of the pixel circuit layer PCL may include various signal lines and/or various voltage lines, which are for driving the display element layer DPL.

The display element layer DPL may be disposed on the pixel circuit layer PCL. The display element layer DPL may include light emitting elements of the sub-pixels SP.

The light conversion layer LFL may be disposed on the display element layer DPL. The light conversion layer LFL may include light conversion patterns having color conversion particles and/or light scattering particles. For example, color conversion particles may include quantum dots. The quantum dots may change a wavelength (or color) of light emitted from the display element layer DPL. The light conversion layer LFL may include light scattering patterns having light scattering particles. In embodiments, the light conversion patterns and the light scattering patterns may be omitted.

The light conversion layer LFL may further include a color filter layer including color filters. The color filter may allow light having a specific wavelength (or specific color) to be selectively transmitted through the color filter. In embodiments, the color filter layer may be omitted.

A window for protecting an exposed surface (or top surface) of the display panel DP may be provided on the light conversion layer LFL. The window may protect the display panel DP from external impact. The window may be bonded to the light conversion layer LFL through an optically transparent adhesive (or cohesive) member. The window may have a multi-layer structure selected from a glass substrate, a plastic film, and a plastic substrate. This multi-layer structure may be formed through a continuous process or an adhesive process using an adhesive layer. The whole or a portion of the window may have flexibility.

FIG. 5 is a cross-sectional view illustrating another embodiment of the display panel shown in FIG. 3.

Referring to FIG. 5, a display panel DP' may include a substrate SUB, a pixel circuit layer PCL, a display element layer DPL, an input sensing layer ISL, and a light conversion layer LFL. The substrate SUB, the pixel circuit layer PCL, the display element layer DPL, and the light conversion layer LFL may be configured similarly to the substrate SUB, the pixel circuit layer PCL, the display element layer DPL, and the light conversion layer LFL, which are described with reference to FIG. 4, respectively. Hereinafter, redundant descriptions will be omitted.

The input sensing layer ISL may sense a user input with respect to a top surface (or display surface) of the display panel DP'. The input sensing layer ISL may include components suitable for sensing an external object such as a hand of a user or a pen. For example, the input sensing layer ISL may include touch electrodes.

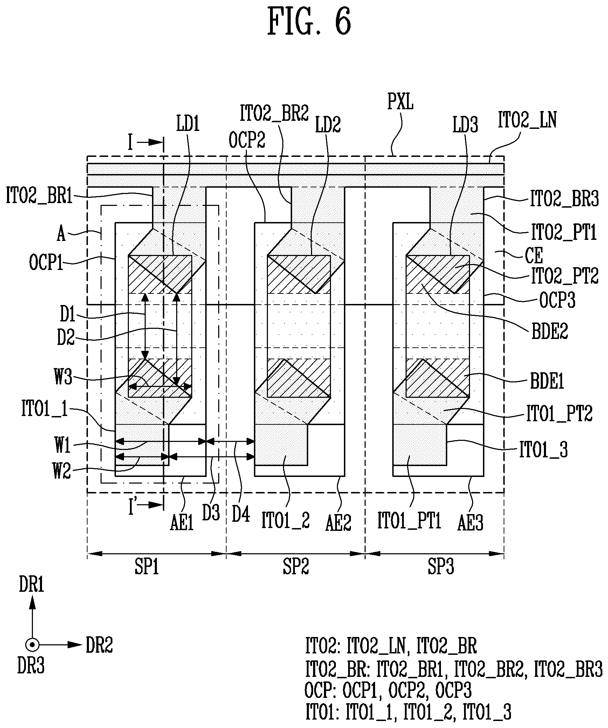

FIG. 6 is a plan view illustrating an embodiment of any one of the pixels shown in FIG. 3.

Referring to FIG. 6, a pixel PXL may include first to third sub-pixels SP1 to SP3. The first to third sub-pixels SP1 to SP3 may be arranged in the second direction DR2.

The pixel PXL may include first to third anode electrodes AE1 to AE3, a cathode electrode CE, overcoat patterns OCP, first to third light emitting elements LD1 to LD3, anode transparent electrodes ITO1, and a cathode transparent electrode ITO2.

In some embodiments, the first to third anode electrodes AE1 to AE3 may be disposed in the first to third sub-pixels SP1 to SP3, respectively. The first anode electrode AE1 may be provided as an anode electrode AE (see FIG. 2) connected to a sub-pixel circuit SPC (see FIG. 2) of the first sub-pixel SP1. The second anode electrode AE2 may be provided as an anode electrode AE connected to a sub-pixel circuit SPC of the second sub-pixel SP2. The third anode electrode AE3 may be provided as an anode electrode AE connected to a sub-pixel circuit SPC of the third sub-pixel SP3.

The cathode electrode CE may be spaced apart from the first to third anode electrodes AE1 to AE3. The cathode electrode CE may be spaced apart from the first to third anode electrodes AE1 to AE3 in the first direction DR1. Also, the cathode electrode CE may extend in the second direction DR2 intersecting the first direction DR1, to be used as a common electrode for all the first to third sub-pixels SP1 to SP3. Although not shown in FIG. 6, the cathode electrode CE may extend in the first and second directions DR1 and DR2, to be used as a common electrode for the pixel PXL and other pixels adjacent to the pixel PXL. As such, the cathode electrode CE may have various shapes.

The overcoat patterns OCP may include a first overcoat pattern OCP1, a second overcoat pattern OCP2, and a third overcoat pattern OCP3. The first to third overcoat patterns OCP1 to OCP3 may be disposed on the first to third anode electrodes AE1 to AE3 and the cathode electrode CE. The first to third anode electrodes AE1 to AE3 and the cathode electrode CE may be partially covered by the first to third overcoat patterns OCP1 to OCP3. In some embodiments, the first to third overcoat patterns OCP1 to OCP3 may overlap a portion of the cathode electrode CE in a plan view. The first to third overcoat patterns OCP1 to OCP3 may respectively overlap the first to third anode electrodes AE1 to AE3 in a plan view.

The first to third overcoat patterns OCP1 to OCP3 may be disposed corresponding to the first to third sub-pixels SP1 to SP3, respectively. The first to third overcoat patterns OCP1 to OCP3 may be spaced apart from each other. Each of the first to third overcoat patterns OCP1 to OCP3 may have an isolated island shape. The first to third overcoat patterns OCP1 to OCP3 may be sequentially disposed along the second direction DR2.

The first to third overcoat patterns OCP1 to OCP3 may include various materials. In some embodiments, the first to third overcoat patterns OCP1 to OCP3 may include an organic material. For example, the first to third overcoat patterns OCP1 to OCP3 may include at least one selected from the group consisting of acrylic resin, epoxy resin, phenolic resin, polyamide resin, and polyimide resin. However, the disclosure is not limited thereto.

The first to third light emitting elements LD1 to LD3 may be included in the first to third sub-pixels SP1 to SP3, respectively. In some embodiments, the first light emitting element LD1 may be electrically connected to the first anode electrode AE1 and the cathode electrode CE. The first light emitting element LD1 may be provided as a light emitting element LD (see FIG. 2) connected to the sub-pixel circuit SPC of the first sub-pixel SP1. The second light emitting element LD2 may be electrically connected to the second anode electrode AE2 and the cathode electrode CE. The second light emitting element LD2 may be provided as a light emitting element LD connected to the sub-pixel circuit SPC of the second sub-pixel SP2. The third light emitting element LD3 may be electrically connected to the third anode electrode AE3 and the cathode electrode CE. The third light emitting element LD3 may be provided as a light emitting element LD connected to the sub-pixel circuit SPC of the third sub-pixel SP3.

The first to third light emitting elements LD1 to LD3 may be inorganic light emitting diodes including an inorganic light emitting material. However, embodiments are not limited thereto. For example, the first to third light emitting elements LD1 to LD3 may be organic light emitting diodes.

The first to third light emitting elements LD1 to LD3 may be disposed on the first to third overcoat patterns OCP1 to OCP3, respectively. The first to third light emitting elements LD1 to LD3 may respectively overlap the first to third overcoat patterns OCP1 to OCP3 in a plan view. Also, the first to third light emitting elements LD1 to LD3 may be in contact with the first to third overcoat patterns OCP1 to OCP3, respectively.

Each of the first to third light emitting elements LD1 to LD3 may include a first element electrode BDE1 and a second element electrode BDE2. The first element electrode BDE1 and the second element electrode BDE2 may be spaced apart from each other in the first direction DR1. The first element electrode BDE1 may be disposed adjacent to a corresponding anode electrode AE, and the second element electrode BDE2 may be disposed adjacent to the cathode electrode CE.

In FIG. 6, it is illustrated that each of the first and second element electrodes BDE1 and BDE2 has a quadrangular shape. However, embodiments are not limited thereto. For example, each of the first and second element electrodes BDE1 and BDE2 may have a " 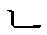 " shape or a " 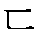 " shape. For example, the first and second element electrodes BDE1 and BDE2 may be formed along side surfaces of a corresponding light emitting element. The first and second element electrodes BDE1 and BDE2 may not be formed in an internal space surrounded by the side surfaces.

The anode transparent electrodes ITO1 and the cathode transparent electrode ITO2 may be disposed on the first to third light emitting elements LD1 to LD3. The anode transparent electrodes ITO1 and the cathode transparent electrode ITO2 may be electrically separated from each other. The anode transparent electrodes ITO1 and the cathode transparent electrode ITO2 may be formed through the same process, and be physically spaced apart from each other.

The anode transparent electrodes ITO1 and the cathode transparent electrode ITO2 may be disposed in the same layer, and include the same transparent conductive material. For example, the transparent conductive material may include at least one selected from the group consisting of silver nano wire (AgNW), Indium Tin Oxide (ITO), Indium Zinc Oxide (IZO), Indium Gallium Zinc Oxide (IGZO), Antimony Zinc Oxide (AZO), Indium Tin Zinc Oxide (ITZO), Zinc Oxide (ZnO), Tin Oxide (SnO₂), carbon nano tube, and graphene. However, the disclosure is not necessarily limited thereto.

The anode transparent electrodes ITO1 may include a first anode transparent electrode ITO1_1, a second anode transparent electrode ITO1_2, and a third anode transparent electrode ITO1_3. The first to third anode transparent electrodes ITO1_1 to ITO1_3 may extend in the first direction DR1, and be spaced apart from each other in the second direction DR2. The first to third anode transparent electrodes ITO1_1 to ITO1_3 may be disposed in the first to third sub-pixels SP1 to SP3, respectively. For example, the first anode transparent electrode ITO1_1 may be disposed in the first sub-pixel SP1. The second anode transparent electrode ITO1_2 may be disposed in the second sub-pixel SP2. The third anode transparent electrode ITO1_3 may be disposed in the third sub-pixel SP3.

The anode transparent electrodes ITO1 may be disposed on the first to third anode electrodes AE1 to AE3. Also, the anode transparent electrodes ITO1 may have a width narrower in the second direction DR2 than a width of the first to third anode electrodes AE1 to AE3. For example, each of the first to third anode electrodes AE1 to AE3 may have a first width W1 in the second direction DR2, and each of the first to third anode transparent electrodes ITO1_1 to ITO1_3 may have a second width W2 in the second direction DR2. The second width W2 may be narrower than the first width W1.

Accordingly, the anode transparent electrodes ITO1 may be spaced apart from each other at a distance greater in the second direction DR2 than a distance between the anode electrodes AE1 to AE3. For example, the first anode transparent electrode ITO1_1 and the second anode transparent electrode ITO1_2 may be spaced apart from each other at a third distance D3 in the second direction DR2. The first anode electrode AE1 and the second anode electrode AE2 may be spaced apart from each other at a fourth distance D4 smaller than the third distance D3.

When the first element electrode BDE1 of each of the first and second light emitting elements LD1 and LD2 has a third width W3 in the second direction DR2, the third distance D3 may be smaller than or equal to a sum of about a half of the third width W3 and the fourth distance D4. Although the first and second sub-pixels SP1 and SP2 have been described in the above, this may be equally applied to the second and third sub-pixels SP2 and SP3.

Each of the anode transparent electrodes ITO1 may overlap at least a portion of a corresponding first element electrode BDE1 in a plan view. For example, the first anode transparent electrode ITO1_1 may overlap at least a portion of the first element electrode BDE1 of the first light emitting element LD1. The first anode transparent electrode ITO1_1 may overlap about 1/3 or more of an area of the first element electrode BDE1 of the first light emitting element LD1. The second anode transparent electrode ITO1_2 may overlap at least a portion of the first element electrode BDE1 of the second light emitting element LD2. The second anode transparent electrode ITO1_2 may overlap about 1/3 or more of an area of the first element electrode BDE1 of the second light emitting element LD2. The third anode transparent electrode ITO1_3 may overlap at least a portion of the first element electrode BDE1 of the third light emitting element LD3. The third anode transparent electrode ITO1_3 may overlap about 1/3 or more of an area of the first element electrode BDE1 of the third light emitting element LD3.

Each of the anode transparent electrodes ITO1 may include a first portion ITO1_PT1 and a second portion ITO1_PT2. The first portion ITO1_PT1 may extend in the first direction DR1. The second portion ITO1_PT2 may extend in a diagonal direction intersecting the first and second directions DR1 and DR2 from the first portion ITO1_PT1. Also, the second portion ITO1_PT2 may overlap a portion of a corresponding first element electrode BDE1.

Each of the anode transparent electrodes ITO1 may be electrically connected to a first element electrode BDE1 of a corresponding light emitting element. For example, the first anode transparent electrode ITO1_1 may electrically connect the first element electrode BDE1 of the first light emitting element LD1 to the first anode electrode AE1. The second anode transparent electrode ITO1_2 may electrically connect the first element electrode BDE1 of the second light emitting element LD2 to the second anode electrode AE2. The third anode transparent electrode ITO1_3 may electrically connect the first element electrode BDE1 of the third light emitting element LD3 to the third anode electrode AE3.

The cathode transparent electrode ITO2 may include a line electrode ITO2_LN and branch electrodes ITO2_BR. The line electrode ITO2_LN may extend in the second direction DR2, and may be disposed throughout the first to third sub-pixels SP1 to SP3. Also, the line electrode ITO2_LN may be disposed while being spaced apart from the overcoat patterns OCP in the first direction DR1 not to overlap the overcoat patterns OCP.

The branch electrodes ITO2_BR may include a first branch electrode ITO2_BR1, a second branch electrode ITO2_BR2, and a third branch electrode ITO2_BR3. The first to third branch electrodes ITO2_BR1 to ITO2_BR3 may extend in the first direction DR1 from the line electrode ITO2_LN, and be spaced apart from each other in the second direction DR2. Also, the first to third branch electrodes ITO2_BR1 to ITO2_BR3 may be disposed in the first to third sub-pixels SP1 to SP3, respectively. For example, the first branch electrode ITO2_BR1 may be disposed in the first sub-pixel SP1. The second branch electrode ITO2_BR2 may be disposed in the second sub-pixel SP2. The third branch electrode ITO2_BR3 may be disposed in the third sub-pixel SP3.

The branch electrodes ITO2_BR may overlap at least a portion of each second element electrode BDE2 in a plan view. For example, the first branch electrode ITO2_BR1 may overlap at least a portion of the second element electrode BDE2 of the first light emitting element LD1. The first branch electrode ITO2_BR1 may overlap about 1/3 or more of an area of the second element electrode BDE2 of the first light emitting element LD1. The second branch electrode ITO2_BR2 may overlap at least a portion of the second element electrode BDE2 of the second light emitting element LD2. The second branch electrode ITO2_BR2 may overlap about 1/3 or more of an area of the second element electrode BDE2 of the second light emitting element LD2. The third branch electrode ITO2_BR3 may overlap at least a portion of the second element electrode BDE2 of the third light emitting element LD3. The third branch electrode ITO2_BR3 may overlap about 1/3 or more of an area of the second element electrode BDE2 of the third light emitting element LD3.

Each of the branch electrodes ITO2_BR may include a first portion ITO2_PT1 and a second portion ITO2_PT2. The first portion ITO2_PT1 may extend in the first direction DR1. The second portion ITO2_PT2 may extend in a diagonal direction intersecting the first and second directions DR1 and DR2 from the first portion ITO2_PT1. Also, the second portion ITO2_PT2 may overlap a portion of a corresponding second element electrode BDE2.

Each of the branch electrodes ITO2_BR may be electrically connected to a second element electrode BDE2 of a corresponding light emitting element. For example, the first branch electrode ITO2_BR1 may electrically connect the second element electrode BDE2 of the first light emitting element LD1 to the cathode electrode CE. The second branch electrode ITO2_BR2 may electrically connect the second element electrode BDE2 of the second light emitting element LD2 to the cathode electrode CE. The third branch electrode ITO2_BR3 may electrically connect the second element electrode BDE2 of the third light emitting element LD3 to the cathode electrode CE.

In some embodiments, the first element electrode BDE1 and the second element electrode BDE2 of each of the first to third light emitting elements LD1 to LD3 may be spaced apart from each other at a first distance D1 in the first direction DR1. The anode transparent electrodes ITO1 and the branch electrodes ITO2_BR may be spaced apart from each other at a second distance D2 greater than or equal to the first distance D1 in the first direction DR1. Accordingly, in a process of forming the anode transparent electrodes ITO1 and the cathode transparent electrode ITO2, the length of a residue pattern PRP formed along a circumference of each overcoat pattern OCP can be increased.

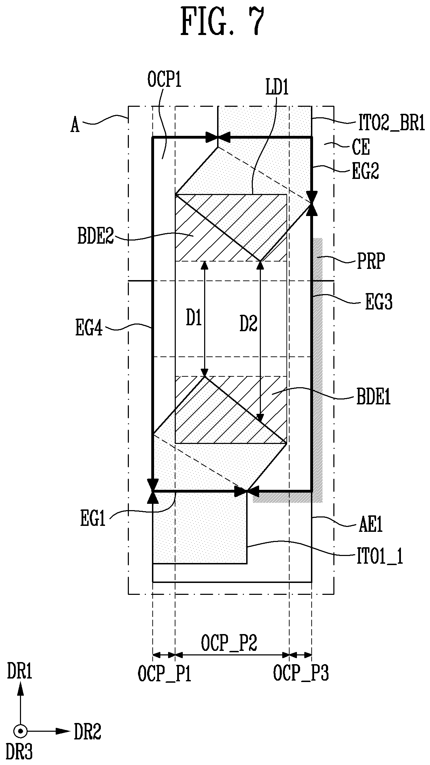

FIG. 7 is an enlarged view illustrating portion A shown in FIG. 6.

Hereinafter, for convenience of description, a first sub-pixel SP1 will be described with reference to FIG. 7, but this may be equally described with respect to other sub-pixels SP.

Referring to FIGS. 6 and 7, the first sub-pixel SP1 may include the first overcoat pattern OCP1, the first light emitting element LD1, the first anode transparent electrode ITO1_1, and the first branch electrode ITO2_BR1 of the cathode transparent electrode ITO2. Hereinafter, descriptions redundant of those aspects described with reference to FIG. 6 will be omitted.

The first element electrode BDE1 and the second element electrode BDE2 of the first light emitting element LD1 may be spaced apart from each other at the first distance D1 in the first direction DR1. The first anode transparent electrode ITO1_1 and the first branch electrode ITO2_BR1 may be spaced apart from each other at the second distance D2 greater than or equal to the first distance D1 in the first direction DR1.

Positions of the first anode transparent electrode ITO1_1 and the first branch electrode ITO2_BR1 with respect to the second direction DR2 may be different from each other. The first overcoat pattern OCP1 may include a first portion OCP_P1, a second portion OCP_P2, and a third portion OCP_P3, which are sequentially disposed in the second direction DR2. The first portion OCP_P1 may overlap the first anode transparent electrode ITO1_1 without overlapping the first branch electrode ITO2_BR1. The second portion OCP_P2 may overlap both the first branch electrode ITO2_BR1 and the first anode transparent electrode ITO1_1. The third portion OCP_P3 may overlap the first branch electrode ITO2_BR1 without overlapping the first anode transparent electrode ITO1_1. As such, the anode transparent electrodes ITO1 the branch electrodes ITO2_BR may be disposed in zigzag along the second direction DR2.

Each of the first to third portions OCP_P1 to OCP_P3 may extend in the first direction DR1 to overlap the first anode electrode AE1 and the cathode electrode CE.

The first overcoat pattern OCP1 may include first to fourth edges EG1 to EG4 along the circumference of the first overcoat OCP1. The first edge EG1 may overlap the first anode transparent electrode ITO1_1, and the second edge EG2 may overlap the first branch electrode ITO2_BR1. The third edge EG3 may connect the first and second edges EG1 and EG2 to each other. The fourth edge EG4 connects the first and second edges EG1 and EG2 to each other, and may be opposite to the third edge EG3. The third edge EG3 or the fourth edge EG4 may have a length longer than the first distance D1 between the first element electrode BDE1 and the second element electrode BDE2 of the first light emitting element LD1.

A residue pattern PRP may be adjacent to the third edge EG3 or the fourth edge EG4. In an example, in a process of forming the anode transparent electrode ITO1 and the cathode transparent electrode ITO2 during a manufacturing process, the first overcoat pattern OCP1 and the first light emitting element LD1 may have a high step difference as compared with a peripheral area. Due to this step difference, the residue pattern PRP may be formed as some residues remain along the circumference of the first overcoat pattern OCP1. The residue pattern PRP may have conductivity. In the case that the residue pattern PRP is disposed between two components which should be electrically blocked from each other, the corresponding components may be unintentionally electrically connected to each other. In accordance with an embodiment of the disclosure, the first anode transparent electrode ITO1_1 and the first branch electrode ITO2_BR may be spaced further apart from each other than the first element electrode BDE1 and the second element electrode BDE2 of the first light emitting element LD1. The residue pattern PRP may be formed to have a length longer than the first distance D1 between the first element electrode BDE1 and the second element electrode BDE2. As such, as the residue pattern PRP is formed long, the first element electrode BDE1 and the second element electrode BDE2 can be prevented from being shortcircuited with each other.

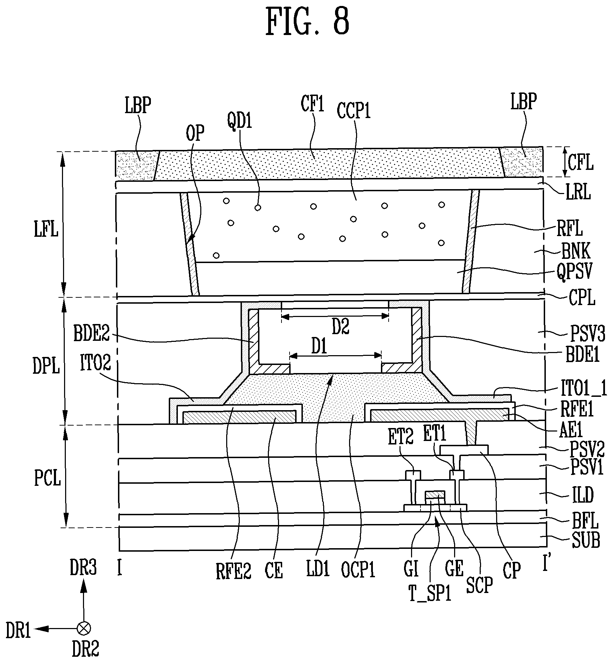

FIG. 8 is a cross-sectional view taken along line I-I' shown in FIG. 6.

Like FIG. 7, in FIG. 8, for convenience of description, the first sub-pixel SP1 will be described, but this may be equally applied to other sub-pixels SP.

Referring to FIG. 8, a pixel circuit layer PCL, a display element layer DPL, and a light conversion layer LFL may be sequentially disposed on a substrate SUB.

The pixel circuit layer PCL may include insulating layers, semiconductor patterns, and conductive patterns, which are stacked on each other on the substrate SUB. The insulating layers may include a buffer layer BFL, one or more interlayer insulating layers ILD, and one or more passivation layers PSV1 and PSV2. The semiconductor patterns and the conductive patterns may be located between the insulating layers. The conductive patterns may include at least one material among copper (Cu), molybdenum (Mo), tungsten (W), aluminium neodymium (AlNd), titanium (Ti), aluminium (Al), and silver (Ag).

As described with reference to FIG. 2, the sub-pixel circuit SPC (see FIG. 2) of each of the first to third sub-pixels SP1 to SP3 may include transistors and one or more capacitors. The semiconductor patterns and the conductive patterns of the pixel circuit layer PCL may serve as the transistors and the capacitors of the sub-pixel circuit SPC. The conductive patterns of the pixel circuit layer PCL may further serve as lines, e.g., the first to mth gate lines GL1 to GLm, the first to nth data lines DL1 to DLn, the power lines PL, and the pixel control lines PXCL, which are shown in FIG. 1.

The buffer layer BFL may be disposed on the substrate SUB. The buffer layer BFL may prevent an impurity from being diffused into circuit elements and lines, which are included in the pixel circuit layer PCL. The buffer layer BFL may include an inorganic insulating layer including an inorganic material. For example, the buffer layer BFL may include at least one of silicon nitride (SiNₓ), silicon oxide (SiOₓ), silicon oxynitride (SiOₓN_{y}), and a metal oxide such as aluminium oxide (AlOₓ). The buffer layer BFL may be provided as a single layer or a multi-layer. In the case that the buffer layer BFL is provided as the multi-layer, layers of the multi-layer may be formed of the same material or be formed of different materials.

A first transistor T_SP1 may be disposed on the buffer layer BFL. The first transistor T_SP1 may be any one of the transistors of the sub-pixel circuit SPC included in the first sub-pixel SP1.

The first transistor T_SP1 may include a semiconductor pattern SCP, a gate electrode GE, a first terminal ET1, and a second terminal ET2. The first terminal ET1 may be any one of a source electrode and a drain electrode, and the second terminal ET2 may be the other of the source electrode and the drain electrode. For example, the first terminal ET1 may be the source electrode, and the second terminal ET2 may be the drain electrode.

The semiconductor pattern SCP may be disposed on the buffer layer BFL. The semiconductor pattern SCP may include a first contact region in contact with the first terminal ET1 and a second contact region in contact with the second terminal ET2. A region between the first contact region and the second contact region may be a channel region. The channel region may overlap the gate electrode GE of the first transistor T_SP1.

The semiconductor pattern SCP may include at least one of various types of semiconductors, e.g., at least one of an amorphous silicon semiconductor, a monocrystalline silicon semiconductor, a polycrystalline silicon semiconductor, a low temperature poly-silicon (LTPS) semiconductor, and an oxide semiconductor.

The sequentially stacked interlayer insulating layers ILD may be disposed over the semiconductor pattern SCP. The interlayer insulating layers ILD may be inorganic insulating layers including an inorganic material. For example, each of the interlayer insulating layers ILD may include at least one of silicon nitride (SiNₓ), silicon oxide (SiOₓ), silicon oxynitride (SiOₓN_{y}), and a metal oxide such as aluminium oxide (AlOₓ). However, the interlayer insulating layers ILD are not limited thereto. For example, at least one of the interlayer insulating layers ILD may include an organic insulating layer including an organic material.

The interlayer insulating layers ILD may electrically separate the conductive patterns and/or the semiconductor patterns, which are disposed between the interlayer insulating layers ILD. For example, the interlayer insulating layers ILD may include a gate insulating layer GI disposed on the semiconductor pattern SCP. The gate insulating layer GI may be disposed between the semiconductor pattern SCP and the gate electrode GE such that the gate electrode GE is spaced apart from the semiconductor pattern SCP. The gate insulating layer GI may be entirely provided on the semiconductor pattern SCP and the buffer layer BFL, to cover the semiconductor pattern SCP and the buffer layer BFL. As the number of layers in the conductive patterns and/or the semiconductor patterns increases, the number of interlayer insulating layers ILD may increase.

The gate electrode GE may be disposed on the gate insulating layer GI. The gate electrode GE may overlap the channel region of the semiconductor pattern SCP. The gate electrode GE may be provided as a single layer including at least one material among copper (Cu), molybdenum (Mo), tungsten (W), aluminium neodymium (AlNd), titanium (Ti), aluminium (Al), and silver (Ag). The gate electrode GE may be provided as a multi-layer including at least one material among molybdenum (Mo), titanium (Ti), copper (Cu), aluminium (Al), and silver (Ag), which are low resistance materials.

The first and second terminals ET1 and ET2 may be disposed on the interlayer insulating layers ILD. The first and second terminals ET1 and ET2 may be in contact with the semiconductor pattern SCP through contact holes penetrating the interlayer insulating layers ILD. The first and second terminals ET1 and ET2 may be in contact with the first and second contact regions of the semiconductor pattern SCP, respectively. Each of the first and second terminals ET1 and ET2 may include at least one material among copper (Cu), molybdenum (Mo), tungsten (W), aluminium neodymium (AlNd), titanium (Ti), aluminium (Al), and silver (Ag).

Although the first and second terminals ET1 and ET2 are illustrated as separate electrodes electrically connected to the semiconductor pattern SCP, embodiments are not limited thereto. For example, the first terminal ET1 may be the first contact region adjacent to a side of the channel region of the semiconductor pattern SCP, and the second terminal ET2 may be the second contact region adjacent to another side of the channel region of the semiconductor pattern SCP. The first terminal ET1 may be electrically connected to a light emitting element LD through a connection means such as a bridge electrode disposed on at least one of the interlayer insulating layers ILD.

In some embodiments, a case where the first transistor T_SP1 is a transistor having a top gate structure is described as an example. However, the disclosure is not limited thereto. For example, the first transistor T_SP1 may be a transistor having a bottom gate structure. The structure of the first transistor T_SP1 may be variously changed.

A first passivation layer PSV1 may be disposed over first transistors T_SP1. The passivation layer may be designated as a protective layer or a via layer. The first passivation layer PSV1 may protect components disposed thereunder, and provide a flat top surface.

A connection pattern CP may be disposed on the first passivation layer PSV1. The connection pattern CP may be connected to the first terminal ET1 of the first transistor T_SP1 while penetrating the first passivation layer PSV1. The connection pattern CP may include at least one material among copper (Cu), molybdenum (Mo), tungsten (W), aluminium neodymium (AlNd), titanium (Ti), aluminium (Al), and silver (Ag).

A second passivation layer PSV2 may be disposed on the connection pattern CP and the first passivation layer PSV1. The second passivation layer PSV2 may protect components disposed thereunder, and provide a flat top surface.

Each of the first and second passivation layers PSV1 and PSV2 may include an inorganic insulating layer including an inorganic material and/or an organic insulating layer including an organic material. For example, the inorganic insulating layer may include at least one of silicon oxide (SiOₓ), silicon nitride (SiNₓ), silicon oxynitride (SiOₓN_{y}), and a metal oxide such as aluminium oxide (AlOₓ). For example, the organic insulating layer may include at least one of acrylic resin, epoxy resin, phenolic resin, polyamide resin, polyimide resin, unsaturated polyester resin, polyphenylene ether resin, poly-phenylene sulfide resin, and benzocyclobutene resin.

The first and second passivation layers PSV1 and PSV2 may include the same material as at least one of the interlayer insulating layers ILD, but embodiments are not limited thereto. Each of the first and second passivation layers PSV1 and PSV2 may be provided as a single layer, but be provided as a multi-layer.

The display element layer DPL may be disposed on the second passivation layer PSV2. The display element layer DPL may include a first anode electrode AE1, a cathode electrode CE, first and second reflective electrodes RFE1 and RFE2, a first light emitting element LD1, a first overcoat pattern OCP1, a first anode transparent electrode ITO1_1, a cathode transparent electrode ITO2, and a capping layer CPL.

The first anode electrode AE1 and the cathode electrode CE may be spaced apart from each other in the first direction DR1. The first anode electrode AE1 may be electrically connected to the first transistor T_SP1 through a contact portion penetrating a portion of the second passivation layer PSV2. The cathode electrode CE may have an extended shape as compared with the first anode electrode AE1, and cover a relatively wide area.

The first reflective electrode RFE1 may be disposed over the first anode electrode AE1. Also, the first reflective electrode RFE1 may be disposed to surround the first anode electrode AE1. The second reflective electrode RFE2 may be disposed over the cathode electrode CE. Also, the second reflective electrode RFE2 may be disposed to surround the cathode electrode CE.

The first and second reflective electrodes RFE1 and RFE2 may include conductive materials suitable for reflecting light. Accordingly, the light emission efficiency of the first light emitting element LD1 can be improved. The first and second reflective electrodes RFE1 and RFE2 may include the same reflective conductive material. For example, the first and second reflective electrodes RFE1 and RFE2 may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), and alloys of two or more materials selected therefrom. However, embodiments are not limited thereto.

The first overcoat pattern OCP1 may be disposed on the second passivation layer PSV2 to be adjacent to the first and second reflective electrodes RFE1 and RFE2. The first overcoat pattern OCP1 may be disposed to partially cover the first anode electrode AE1 and the cathode electrode CE. The first overcoat pattern OCP1 may fix the first light emitting element LD1 not to move. Also, the first overcoat pattern OCP1 may protect components disposed thereunder from foreign matters such as dust and moisture. For example, the first overcoat pattern OCP1 may include at least one of an inorganic insulating layer and an organic insulating layer. For example, the first overcoat pattern may include epoxy, but embodiments are not limited thereto.

The first light emitting element LD1 may be disposed on the first overcoat pattern OCP1. The first light emitting element LD1 may include first and second element electrodes BDE1 and BDE2 which are disposed to face each other while facing in the same direction (e.g., a direction opposite to the third direction DR1). The first and second element electrodes BDE1 and BDE2 may be spaced apart from each other in the first direction DR1. For example, the first and second element electrodes BDE1 and BDE2 may be spaced apart from each other at a first distance D1 in the first direction DR1.

The first element electrode BDE1 may be in contact with sides surfaces of the first light emitting element LD1 and a bottom surface of the first light emitting element LD1. The first element electrode BDE1 may be disposed on the first overcoat pattern OCP1, to be disposed between the first light emitting element LD1 and the first overcoat pattern OCP1.

The first element electrode BDE1 may be electrically connected to a first semiconductor layer (not shown) included in the first light emitting element LD1. In an example, the first semiconductor layer may include at least one p-type semiconductor layer. For example, the first semiconductor layer may include at least one semiconductor material among gallium nitride (GaN), aluminium gallium nitride (AlGaN), indium gallium nitride (InGaN), aluminium nitride (AlN), and indium nitride (InN), and be a p-type semiconductor layer doped with a first conductive dopant (or p-type dopant) such as magnesium (Mg), zinc (Zn), calcium (Ca), strontium (Sr) or barium (Ba). However, the material constituting the first semiconductor layer is not limited thereto. Various materials may constitute the first semiconductor layer.

The second element electrode BDE2 may be in contact with sides surfaces of the first light emitting element LD1 and a bottom surface of the first light emitting element LD1. The second element electrode BDE2 may be disposed on the first overcoat pattern OCP1, to be disposed between the first light emitting element LD1 and the first overcoat pattern OCP1.

The second element electrode BDE2 may be connected to a second semiconductor layer (not shown) included in the first light emitting element LD1. In an example, the second semiconductor layer may include at least one n-type semiconductor layer. For example, the second semiconductor layer may include at least one semiconductor material among gallium nitride (GaN), aluminium gallium nitride (AlGaN), indium gallium nitride (InGaN), aluminium nitride (AlN), and indium nitride (InN), and be an n-type semiconductor layer doped with a second conductive dopant (or n-type dopant) such as silicon (Si), germanium (Ge) or tin (Sn). However, the material constituting the second semiconductor layer is not limited thereto. Various materials may constitute the second semiconductor layer.

The first anode transparent electrode ITO1_1 may be electrically connected to the first reflective electrode RFE1 and the first element electrode BDE1. Accordingly, the first element electrode BDE1 may be electrically connected to the first anode electrode AE1 through the first anode transparent electrode ITO1_1 and the first reflective electrode RFE1.

The first anode transparent electrode ITO1_1 may be disposed at an exposed portion of the first element electrode BDE1 of the first light emitting element LD1, an exposed portion of the first overcoat pattern OCP1, and an exposed portion of the first reflective electrode RFE1. Also, the first anode transparent electrode ITO1_1 may be disposed to overlap a portion of the first element electrode BDE1 in a plan view.

The cathode transparent electrode ITO2 may be electrically connected to the second reflective electrode RFE2 and the second element electrode BDE2. Accordingly, the second element electrode BDE2 may be electrically connected to the cathode electrode CE through the cathode transparent electrode ITO2 and the second reflective electrode RFE2.

The cathode transparent electrode ITO2 may be disposed at an exposed portion of the second element electrode BDE2 of the first light emitting element LD1, an exposed portion of the first overcoat pattern OCP1, and an exposed portion of the second reflective electrode RFE2. Also, the cathode transparent electrode ITO2 (e.g., the first branch electrode ITO2_BR1 (see FIG. 7)) may be disposed to overlap a portion of the second element electrode BDE2 in a plan view.

In some embodiments, the first anode transparent electrode ITO1_1 and the cathode transparent electrode ITO2 may be substantially transparent or translucent to satisfy a predetermined or selected light transmittance. The first anode transparent electrode ITO1_1 and the cathode transparent electrode ITO2 may be disposed in the same display element layer DPL, and include the same transparent conductive material. For example, the first anode transparent electrode ITO1_1 and the cathode transparent electrode ITO2 may include at least one of various transparent conductive materials such as indium tin oxide (ITO), indium zinc oxide (IZO), zinc oxide (ZnO), indium gallium zinc oxide (IGZO), and indium tin zinc oxide (ITZO). However, embodiments are not limited thereto.

In embodiments, as the first light emitting element LD1 is disposed on the first overcoat pattern OCP1, the first overcoat pattern OCP1 and the first light emitting element LD1 may have a high step difference as compared with a peripheral area. For example, the first overcoat pattern OCP1 and the first light emitting element LD1 may have a step difference of about 7 µm. Therefore, in the case that a photoresist (PR) is applied and light-exposed in a process of forming the first anode transparent electrode ITO1_1 and the cathode transparent electrode ITO2, some residues may remain along the circumference of the first overcoat pattern OCP1. A residue pattern PRP (see FIG. 7) may be formed due to these residues. In particular, as the distance between the first and second light emitting elements LD1 and LD2 becomes narrower, the distance between at least one of the first and second anode electrodes AE1 and AE2 and the cathode electrode CE or between the first and second anode electrodes AE1 and AE2 may become closer.

Accordingly, a short circuit caused by the residue pattern PRP may occur between at least one of the first and second anode electrodes AE1 and AE2 and the cathode electrode CE or between the first and second anode electrodes AE1 and AE2. In order to prevent the short circuit caused by the residue pattern PRP, the first anode transparent electrode ITO1_1 and the cathode transparent electrode ITO2 may be spaced further apart from each other than the first and second element electrodes BDE1 and BDE2. For example, the first anode transparent electrode ITO1_1 and the cathode transparent electrode ITO2 may be spaced apart from each other at a second distance D2 in the first direction DR1. The second distance D2 is greater than or equal to the first distance D1.

As such, the first anode transparent electrode ITO1_1 and the cathode transparent electrode ITO2 may be spaced further apart from each other than the first and second element electrodes BDE1 and BDE2, so that the length of the residue pattern PRP can be maximized, thereby preventing the short circuit caused by the residue pattern PRP.

A third passivation layer PSV3 may be disposed over the first anode transparent electrode ITO1_1 and the cathode transparent electrode ITO2. The third passivation layer PSV3 may protect components disposed thereunder, and provide a flat top surface. The third passivation layer PSV3 may include the same material as at least one of the first and second passivation layers PSV1 and PSV2, but embodiments are not limited thereto.

The capping layer CPL may be disposed on the third passivation layer PSV3. The capping layer CPL may protect components disposed thereunder, such as the first light emitting element LD1, from external moisture, humidity, and the like. In some embodiments, the capping layer CPL may entirely cover the first light emitting element LD1 and the third passivation layer PSV3. The capping layer CPL may include at least one of silicon nitride (SiNₓ), silicon oxide (SiOₓ), silicon oxynitride (SiOₓN_{y}), and a metal oxide such as aluminium oxide (AlOₓ). However, the material of the capping layer CPL is not limited thereto.

The light conversion layer LFL may be disposed on the capping layer CPL. The light conversion layer LFL may include a bank BNK, a reflective layer RFL, an intermediate passivation layer QPSV, a first light conversion pattern CCP1, a low refractive layer LRL, and a color filter layer CFL.

The bank BNK may be disposed on the capping layer CPL. The bank BNK may have an opening OP. The bank BNK may include a light blocking material, to prevent light mixture between adjacent sub-pixels. For example, the bank BNK may include an organic insulating material such as acrylic resin, epoxy resin, phenolic resin, polyamide resin, or polyimide resin.

The reflective layer RFL may be disposed on side surfaces of the bank BNK, which are adjacent to the opening OP. The reflective layer RFL may be configured to reflect incident light, and accordingly, light emission efficiency can be improved. The reflective layer RFL may include a material suitable for reflecting light. The reflective layer RFL may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), and alloys of two or more materials selected therefrom. However, embodiments are not limited thereto.

The intermediate passivation layer QPSV may be disposed in the opening OP on the capping layer CPL. The intermediate passivation layer QPSV may protect components disposed thereunder, and provide a flat top surface. The intermediate passivation layer QPSV may include the same material as at least one of the first to third passivation layers PSV1 to PSV3, but embodiments are not limited thereto.

The first light conversion pattern CCP1 may be disposed on the intermediate passivation layer QPSV in the opening OP. The first light conversion pattern CCP1 may include color conversion particles and/or light scattering particles. The color conversion particles may convert incident light into light of another color by changing a wavelength of the incident light. Also, the color conversion particles may scatter incident light. In embodiments, the color conversion particles may be quantum dots. The light scattering particles may scatter incident light.

The first sub-pixel SP1 may be a red sub-pixel. In the case that the first light emitting element LD1 emits light of a blue color, the first light conversion pattern CCP1 may include first color conversion particles QD1 configured to convert light of the blue color into light of a red color. In the case that the first light emitting element LD1 emits light of the red color, the first light conversion pattern CCP1 may include light scattering particles. As such, the particles included in the first light conversion pattern CCP1 may be variously changed according to the first light emitting element LD1.

The low refractive layer LRL may be disposed on the bank BNK, the reflective layer RFL, and the first light conversion pattern CCP1. The low refractive layer LRL may have a refractive index lower than a refractive index of the first light conversion pattern CCP1. The low refractive layer LRL may be configured to refract or totally reflect light according to an incident angle of the corresponding light. For example, the low refractive layer LRL may again provide light passing through the first light conversion pattern CCP1 to the first light conversion pattern CCP1. Accordingly, the light conversion efficiency of the first light conversion pattern CCP1 can be improved.

The color filter layer CFL may be disposed on the low refractive layer LRL. The color filter layer CFL may include a first color filter CF1 and light blocking patterns LBP. The first color filter CF1 may overlap the first light conversion pattern CCP1. The first color filter CF1 may allow light in a desired wavelength range to be selectively transmitted through the first color filter CF1. In the case that the first sub-pixel SP1 is a red sub-pixel, the first color filter CF1 may include a red color filter. The light blocking patterns LBP may include at least one of various kinds of light blocking materials.

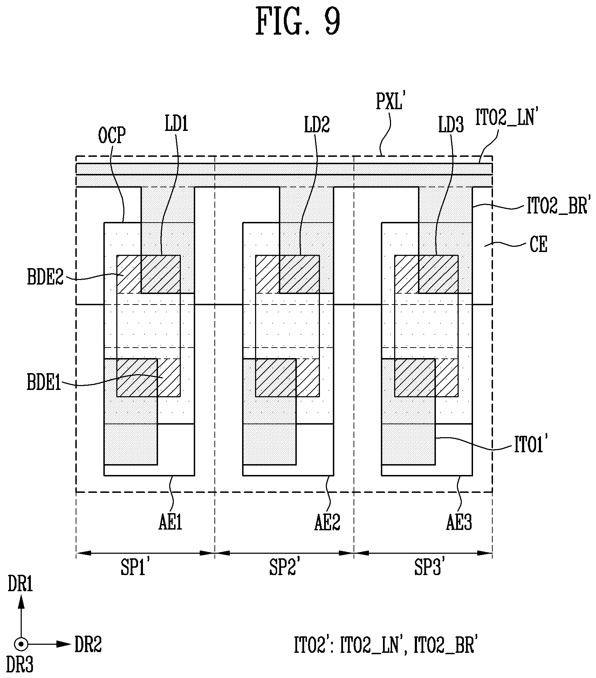

FIGS. 9 to 11 are plan views illustrating other embodiments of any one of the pixels shown in FIG. 1.

Referring to FIG. 9, a pixel PXL' may include first to third sub-pixels SP1' to SP3'. The first to third sub-pixels SP1' to SP3' may be arranged in the second direction DR2. The pixel PXL' may include first to third anode electrodes AE1 to AE3, a cathode electrode CE, overcoat patterns OCP, and first to third light emitting elements LD1 to LD3.

The first to third anode electrodes AE1 to AE3, the cathode electrode CE, the overcoat patterns OCP, and the first to third light emitting elements LD1 to LD3 may be similar to the embodiments shown in FIG. 6. In relation to the embodiments shown in FIG. 6, redundant descriptions will be omitted, and portions different from those of the above-described embodiments will be described.

Anode transparent electrodes ITO1' and a cathode transparent electrode ITO2' may be disposed on the first to third light emitting elements LD1 to LD3. The anode transparent electrodes ITO1' and a cathode transparent electrode ITO2' may be electrically separated from each other. The anode transparent electrodes ITO1' and a cathode transparent electrode ITO2' may be formed through the same process, and be physically spaced apart from each other.

The anode transparent electrodes ITO1' may extend in the first direction DR1, and be spaced apart from each other in the second direction DR2. For example, the anode transparent electrodes ITO1' may have a rectangular shape in a plan view.

Each of the anode transparent electrodes ITO1' may overlap at least a portion of a first element electrode BDE1 of a corresponding light emitting element in a plan view. For example, each of the anode transparent electrodes ITO1' may overlap about a half of an area of the first element electrode BDE1. That is, another half of the area of the first element electrode BDE1 may not overlap a corresponding anode transparent electrode. In some embodiments, although FIG. 9 is described as an example, the overlapping area is not limited to about a half. For example, each of the anode transparent electrodes ITO1' may overlap about 1/3 or more of the area of the first element electrode BDE1.

Accordingly, portions of the overcoat patterns OCP, which overlap the first to third anode electrodes AE1 to AE3, may not overlap the anode transparent electrodes ITO1'.

The cathode transparent electrode ITO2' may include a line electrode ITO2_LN' and branch electrodes ITO2_BR'. The line electrode ITO2_LN' may extend in the second direction DR2, and be disposed throughout the first to third sub-pixels SP1 to SP3. Also, the line electrode ITO2_LN' may be disposed while being spaced apart from the overcoat patterns OCP in the first direction DR1 not to overlap the overcoat patterns OCP.

The branch electrodes ITO2_BR' may extend in the first direction DR1 from the line electrode ITO2_LN', and be spaced apart from each other in the second direction DR2. For example, the branch electrodes ITO2_BR' may have a rectangular shape in a plan view.

Each of the branch electrodes ITO2_BR' may overlap at least a portion of a second element electrode BDE2 of a corresponding light emitting element in a plan view. For example, each of the branch electrodes ITO2_BR' may overlap about a half of an area of the second element electrode BDE1. That is, another half of the area of the second element electrode BDE2 may not overlap the corresponding branch electrode. In some embodiments, although FIG. 9 is described as an example, the overlapping area is not limited to about a half. For example, each of the branch electrodes ITO2_BR' may overlap about 1/3 or more of the area of the second element electrode BDE2.

Accordingly, portions of the overcoat patterns OCP, which overlap the cathode electrode CE, may not overlap the branch electrodes ITO2_BR'.

The anode transparent electrodes ITO1' and the branch electrodes ITO2_BR' may be spaced further apart from each other in the first direction DR1 than the first element electrode BDE1 and the second element electrode BDE2 of each of the first to third light emitting elements LD1 to LD3. The anode transparent electrodes ITO1' may be spaced apart from a side of the first element electrode BDE1 in the opposite direction of the second direction DR2, and overlap a portion of the first element electrode BDE1. On the other hand, the branch electrodes ITO2_BR' may be spaced apart from a side of the second element electrode BDE2 in the second direction DR2, and overlap a portion of the second element electrode BDE2. Accordingly, the anode transparent electrodes ITO1' and the branch electrodes ITO2_BR' may be disposed such that central axes thereof, which extend in the first direction DR1, are dislocated from each other.

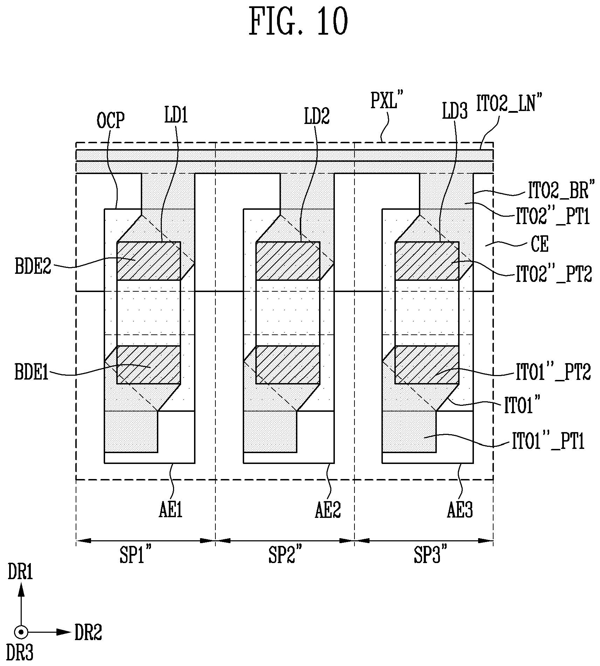

Referring to FIG. 10, a pixel PXL" may include first to third sub-pixels SP1" to SP3". The pixel PXL" may include first to third anode electrodes AE1 to AE3, a cathode electrode CE, overcoat patterns OCP, and first to third light emitting elements LD1 to LD3.

The first to third anode electrodes AE1 to AE3, the cathode electrode CE, the overcoat patterns OCP, and the first to third light emitting elements LD1 to LD3 may be similar to the embodiments shown in FIG. 6. Hereinafter, descriptions redundant of those aspects described with reference to FIGS. 6 and 9 will be omitted, and portions different from those of the above-described embodiments will be described.

Anode transparent electrodes ITO1" and a cathode transparent electrode ITO2" may be disposed on the first to third light emitting elements LD1 to LD3. The anode transparent electrodes ITO1" and the cathode transparent electrode ITO2" may be electrically separated from each other. The anode transparent electrodes ITO1" and the cathode transparent electrode ITO2" may be formed through the same process, and be physically spaced apart from each other.

The anode transparent electrodes ITO1" may extend in the first direction DR1, and be spaced apart from each other in the second direction DR2. Also, each of the anode transparent electrodes ITO1" may include a first portion ITO1"_PT1 and a second portion ITO1"_PT2. The first portion ITO1"_PT1 may extend in the first direction DR1. The second portion ITO1"_PT2 may extend in a diagonal direction intersecting the first and second directions DR1 and DR2 from the first portion ITO1"_PT1.

The anode transparent electrodes ITO1" may overlap first element electrodes BDE1 of the first to third light emitting elements LD1 to LD3 in a plan view. For example, each of the anode transparent electrodes ITO1" may overlap the entire area of the first element electrode BDE1. However, at least portions of the overcoat patterns OCP overlapping the first to third anode electrodes AE1 to AE3 may not overlap the anode transparent electrodes ITO1".

The cathode transparent electrode ITO2" may include a line electrode ITO2_LN" and branch electrodes ITO2_BR". The line electrode ITO2_LN" may extend in the second direction DR2, and be disposed throughout the first to third sub-pixels SP1 to SP3. Also, the line electrode ITO2_LN" may be disposed while being spaced apart from the overcoat patterns OCP in the first direction DR1 not to overlap the overcoat patterns OCP.

The branch electrodes ITO2_BR" may extend in the first direction DR1 from the line electrode ITO2_LN", and be spaced apart from each other in the second direction DR2. Each of the branch electrodes ITO2_BR" may include a first portion ITO2"_PT1 and a second portion ITO2"_PT2. The first portion ITO2"_PT1 may extend in the first direction DR1. The second portion ITO2"_PT2 may extend in a diagonal direction intersecting the first and second directions DR1 and DR2 from the first portion ITO2"_PT1. However, the diagonal direction in which the second portion ITO2''_PT2 of each of the branch electrodes ITO2_BR'' extends may be a direction opposite to the diagonal direction in which the second portion ITO1''_PT2 of each of the anode transparent electrodes ITO1'' extends.

The branch electrodes ITO2_BR'' may overlap second element electrodes BDE2 of the first to third light emitting elements LD1 to LD3 in a plan view. For example, each of the branch electrodes ITO2_BR'' may overlap the entire area of the second element electrode BDE2. However, at least portions of the overcoat patterns OCP overlapping the cathode electrode CE may not overlap the branch electrodes ITO2_BR''.

The anode transparent electrodes ITO1'' and the branch electrodes ITO2_BR'' may be spaced apart from each other in the first direction DR1. A distance between one of the anode transparent electrodes ITO1'' one of the branch electrodes ITO2_BR'' in the first direction DR1 may be substantially equal to a distance between the first element electrode BDE1 and the second element electrode BDE2 of any one of the first to third light emitting elements LD1 to LD3. The first portion ITO1''_PT1 of each anode transparent electrode ITO1'' may be spaced apart from a side of a corresponding anode electrode in the opposite direction of the second direction DR2, and overlap a portion of the corresponding anode electrode. On the other hand, the first portion ITO2''_PT1 of each branch electrode ITO2_BR'' may be spaced apart from a side of the cathode electrode CE in the second direction DR2, and overlap a portion of the cathode electrode CE. Accordingly, the first portions ITO1''_PT1 of the anode transparent electrodes ITO1'' and the first portions ITO2''_PT1 of the branch electrodes ITO2_BR'' may be disposed such that central axes thereof, which extend in the first direction DR1, are dislocated from each other.

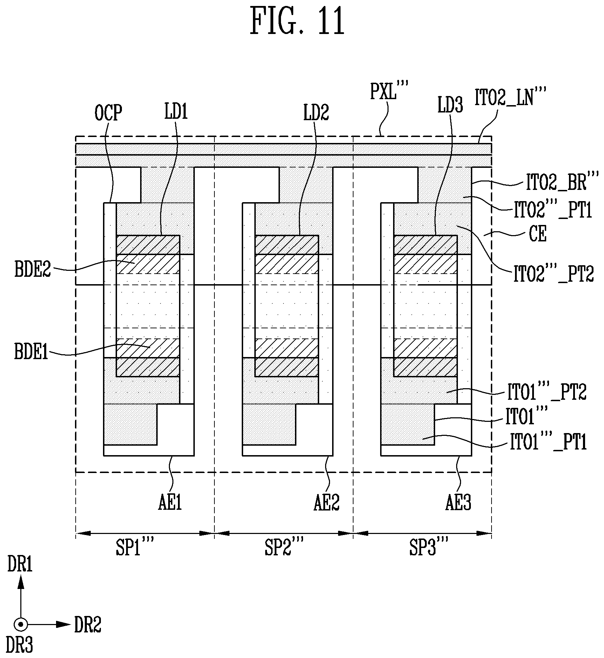

Referring to FIG. 11, a pixel PXL‴ may include first to third sub-pixels SP1‴ to SP3‴. The pixel PXL‴ may include first to third anode electrodes AE1 to AE3, a cathode electrode CE, overcoat patterns OCP, and first to third light emitting elements LD1 to LD3.

The first to third anode electrodes AE1 to AE3, the cathode electrode CE, the overcoat patterns OCP, and the first to third light emitting elements LD1 to LD3 may be similar to the embodiments shown in FIG. 6. Hereinafter, descriptions overlapping those shown in FIGS. 6, 9, and 10 will be omitted, and portions different from those of the above-described embodiments will be described.

Anode transparent electrodes ITO1‴ and a cathode transparent electrode ITO2‴ may be disposed on the first to third light emitting elements LD1 to LD3. The anode transparent electrodes ITO1‴ and the cathode transparent electrode ITO2‴ may be electrically separated from each other. The anode transparent electrodes ITO1‴ and the cathode transparent electrode ITO2‴ may be formed through the same process, and be physically spaced apart from each other.

The anode transparent electrodes ITO1‴ may extend in the first direction DR1, and be spaced apart from each other in the second direction DR2. Also, each of the anode transparent electrodes ITO1‴ may include a first portion ITO1‴_PT1 and a second portion ITO1‴_PT2. The first portion ITO1‴_PT1 may extend in the first direction DR1. The second portion ITO1‴_PT2 may extend in the second direction DR2 intersecting the first direction DR1 from the first portion ITO1‴_PT1.

The anode transparent electrodes ITO1‴ may respectively overlap first element electrodes BDE1 of the first to third light emitting elements LD1 to LD3 in a plan view. For example, the second portion ITO1‴_PT2 of each of the anode transparent electrodes ITO1‴ may overlap about a half of an area of the first element electrode BDE1. Another half of the area of the first element electrode BDE1 may not overlap a second portion ITO1‴_PT2 of a corresponding anode transparent electrode. In some embodiments, although FIG. 11 is described as an example, the overlapping area is not limited to about a half. For example, each of the anode transparent electrodes ITO1‴ may overlap about 1/3 or more of the area of the first element electrode BDE1.

Accordingly, at least portions of the overcoat patterns OCP overlapping the first to third anode electrodes AE1 to AE3 may not overlap the anode transparent electrodes ITO1‴.

The cathode transparent electrode ITO2‴ may include a line electrode ITO2_LN‴ and branch electrodes ITO2_BR‴. The line electrode ITO2_LN‴ may extend in the second direction DR2, and be disposed throughout the first to third sub-pixels SP1 to SP3. Also, the line electrode ITO2_LN‴ may be disposed while being spaced apart from the overcoat patterns OCP in the first direction DR1 not to overlap the overcoat patterns OCP.

The branch electrodes ITO2_BR‴ may extend in the first direction DR1 from the line electrode ITO2_LN‴, and be spaced apart from each other in the second direction DR2. Each of the branch electrodes ITO2_BR‴ may include a first portion ITO2‴_PT1 and a second portion ITO2‴_PT2. The first portion ITO2‴_PT1 may extend in the first direction DR1. The second portion ITO2‴_PT2 may extend in the second direction DR2 intersecting the first direction DR1 from the first portion ITO2‴_PT1.

The branch electrodes ITO2_BR‴ may respectively overlap second element electrodes BDE2 of the first to third light emitting elements LD1 to LD3 in a plan view. For example, the second portion ITO2‴_PT2 of each of the branch electrodes ITO2_BR‴ may overlap about a half of an area of the second element electrode BDE2. Another half of the area of the second element electrode BDE2 may not overlap the second portion ITO2‴_PT2 of the corresponding branch electrode. In some embodiments, although FIG. 11 is described as an example, the overlapping area is not limited to about a half. For example, each of the branch electrodes ITO2_BR‴ may overlap about 1/3 or more of the area of the second element electrode BDE2.

Accordingly, at least some portions of the overcoat patterns OCP overlapping the first to third anode electrodes AE1 to AE3 may not overlap the branch electrodes ITO2_BR‴.

The anode transparent electrodes ITO1‴ and the branch electrodes ITO2_BR‴ may be spaced further apart from each other in the first direction DR1 than the first element electrode BDE1 and the second element electrode BDE2 of each of the first to third light emitting elements LD1 to LD3. The first and second portions ITO1‴_PT1 and ITO1‴_PT2 of each of the anode transparent electrodes ITO1‴ may be spaced apart from a side of a corresponding anode electrode in the opposite direction of the second direction DR2, and overlap a portion of the corresponding anode electrode. The first portion ITO1‴_PT1 may be spaced further apart from the side of each of the first to third anode electrodes AE1 to AE3 in the opposite direction of the second direction DR2 than the second portion ITO1‴_PT2. The first and second portions ITO1‴_PT1 and ITO1‴_PT2 may be adjacent to another side of each of the first to third anode electrodes AE1 to AE3.

On the other hand, the first and second portions ITO1‴_PT1 and ITO1‴_PT2 of the branch electrodes ITO2_BR‴ may be spaced apart from an end of the cathode electrode CE in the opposite direction of the second direction DR2, to overlap a portion of the cathode electrode CE in the second direction DR2. However, the first portion ITO2‴_PT1 may be spaced further apart from a side of the cathode electrode CE in the second direction DR2 than the second portion ITO2‴_PT2. The first and second portions ITO1‴_PT1 and ITO1‴_PT2 may be adjacent to another side of the cathode electrode CE.

Accordingly, the first portions ITO1‴_PT1 of the anode transparent electrodes ITO1‴ and the first portions ITO2‴_PT1 of the branch electrodes ITO2_BR‴ may be disposed such that central axes thereof, which extend in the first direction DR1, are dislocated from each other.

However, although a case where the anode transparent electrodes ITO1' and the branch electrodes ITO2_BR' have shapes symmetrical to each other in a plan view is illustrated in each of FIGS. 6, 9, 10, and 11, the anode transparent electrodes ITO1' and the branch electrodes ITO2_BR' may have different shapes.

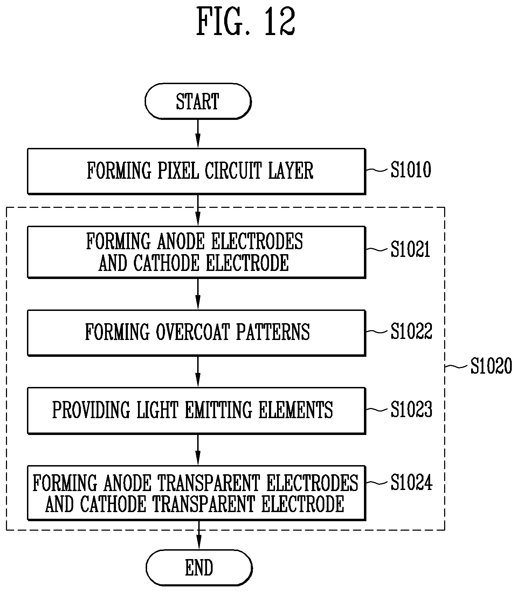

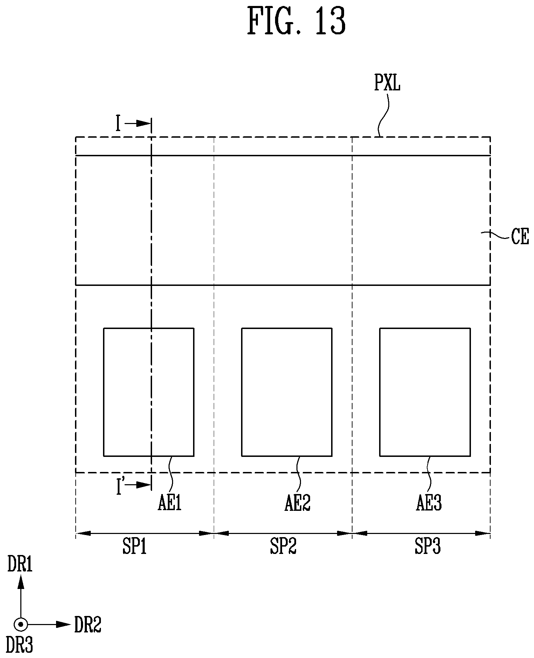

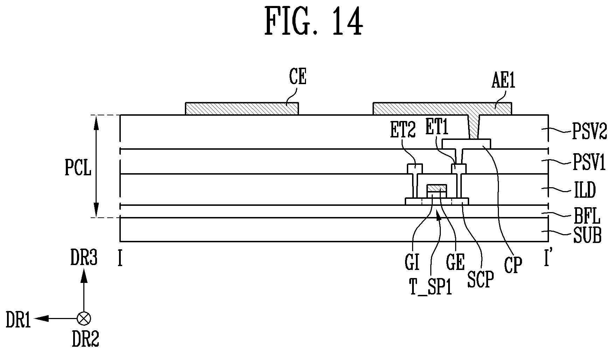

FIG. 12 is a flowchart illustrating an embodiment of a method of manufacturing the display device shown in FIG. 1. FIG. 13 is a plan view of the display device in S1021 shown in FIG. 12. FIG. 14 is a cross-sectional view taken along line I-I' shown in FIG. 13. Hereinafter, line I-I' shown in each of FIGS. 13, 15, 17, and 19 is understood as a cutting plane line at the same position as line I-I' shown in FIG. 6.

First, referring to FIG. 12, the method of manufacturing the display device DD in accordance with an embodiment of the disclosure may include step S1010 of forming a pixel circuit layer and step S1020 of forming a display element layer. The step S1020 of forming the display element layer may include step S1021 of forming anode electrodes and a cathode electrode, step S1022 of forming overcoat patterns, step S1023 of providing light emitting elements, and step S1024 of forming anode transparent electrodes and a cathode transparent electrode.

Referring to FIGS. 12, 13, and 14, in S1010, a pixel circuit layer PCL may be formed on a substrate SUB. In S1021 of S1020, first to third anode electrodes AE1 to AE3 and a cathode electrode CE may be formed on the pixel circuit layer PCL (or the substrate SUB).

In some embodiments, the pixel circuit layer PCL on the substrate SUB may be formed based on an ordinary process for manufacturing a semiconductor device. For example, a conductive layer or an insulating layer, which is included in the pixel circuit layer PCL, may be formed through a photolithography process. In other embodiments, the conductive layer or the insulating layer, which is included in the pixel circuit layer PCL, may be etched through various processes (wet etching, dry etching, and the like), and be deposited through various processes (sputtering, chemical vapor deposition, and the like). However, embodiments are not limited thereto.

A first transistor T_SP1 may be formed on the substrate SUB, and a buffer layer BFL, interlayer insulating layers ILD, a first passivation layer PSV1, and a second passivation layer PSV2 may be formed.

The first transistor T_SP1 may be any one of transistors of a sub-pixel circuit included in a first sub-pixel SP1. The first transistor T_SP1 may include a semiconductor pattern SCP, a gate electrode GE, a first terminal ET1, and a second terminal ET2. A gate insulating layer GI may be disposed between the semiconductor pattern SCP and the gate electrode GE. The first transistor T_SP1 may be electrically connected to the first anode electrode AE1 through a connection pattern CP.

The cathode electrode CE may be formed on the pixel circuit layer PCL. For example, the cathode electrode CE may extend in the second direction DR2 to cover first to third sub-pixels SP1 to SP3.

In some embodiments, an area in which the cathode electrode CE is formed may correspond to an area in which first to third light emitting elements LD1 to LD3, overcoat patterns OCP, and a cathode transparent electrode ITO2 are disposed in subsequent processes.

The first to third anode electrodes AE1 to AE3 may be formed on the pixel circuit layer PCL. For example, the first to third anode electrodes AE1 to AE3 may be formed to be spaced apart from each other in the first direction DR1 from the cathode electrode CE. Also, the first to third anode electrodes AE1 to AE3 may be spaced apart from each other in the second direction DR2, to be isolated from each other.

In some embodiments, the area in which the cathode electrode CE is formed may correspond to an area in which the first to third light emitting elements LD1 to LD3, the overcoat patterns OCP, and anode transparent electrodes ITO1 are disposed in subsequent processes.

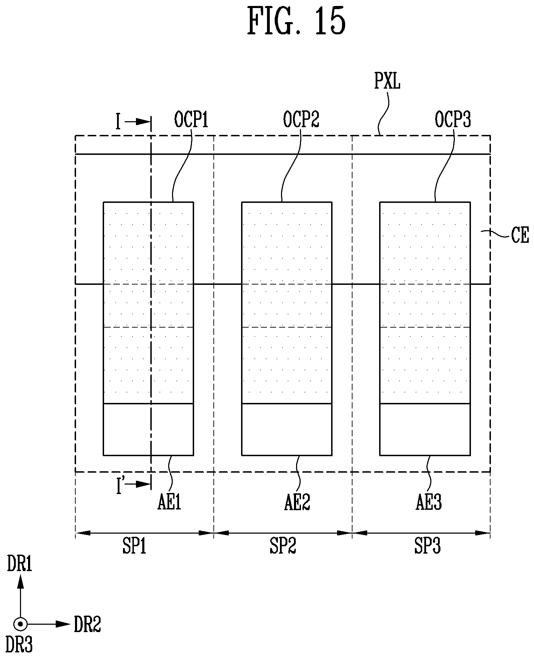

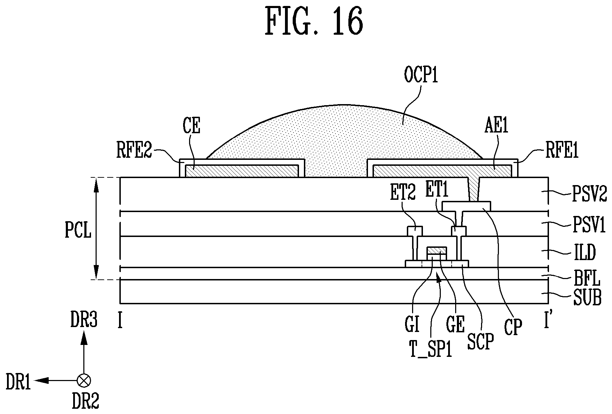

FIG. 15 is a plan view of the display device in S1022 shown in FIG. 12. FIG. 16 is a cross-sectional view taken along line I-I' shown in FIG. 15.

Referring to FIGS. 12, 15, and 16, in S1022 of S1020, first to third overcoat patterns OCP1 to OCP3 may be formed on the first to third anode electrodes AE1 to AE3 and the cathode electrode CE.

In some embodiments, the first to third overcoat patterns OCP1 to OCP3 may be formed on the pixel circuit layer PCL (or the substrate SUB), based on a process such as deposition. In an example, after the first to third overcoat patterns OCP1 to OCP3 are formed, an additional etching process may be further performed. For example, although not shown in the drawings, grooves may be further formed in the first to third overcoat patterns OCP1 to OCP3 through the additional etching process. As the first to third light emitting elements LD1 to LD3 are respectively disposed on the grooves of the first to third overcoat patterns OCP1 to OCP3, the alignment degree of the first to third light emitting elements LD1 to LD3 can be further improved.

In some embodiments, first and second reflective electrodes RFE1 and RFE2 may be formed over the first to third anode electrodes AE1 to AE3 and the cathode electrode CE. For example, the first reflective electrode RFE1 may be formed to cover the first anode electrode AE1. The second reflective electrode RFE2 may be formed to cover the cathode electrode CE.

The first to third overcoat patterns OCP1 to OCP3 may be formed on the first to third anode electrodes AE1 to AE3 and the cathode electrode CE. The first to third overcoat patterns OCP1 to OCP3 may extend in the first direction DR1, and be formed to be spaced apart from each other in the second direction DR2. Also, the first to third overcoat patterns OCP1 to OCP3 may partially cover the first to third anode electrodes AE1 to AE3 and the cathode electrode CE. For example, the first overcoat pattern OCP1 may be disposed to overlap a portion of the first anode electrode AE1 and a portion of the cathode electrode CE. The second overcoat pattern OCP2 may be disposed to overlap a portion of the second anode electrode AE2 and a portion of the cathode electrode CE. The third overcoat pattern OCP3 may be disposed to overlap a portion of the third anode electrode AE3 and a portion of cathode electrode CE. Each of the first to third overcoat patterns OCP1 to OCP3 may be disposed to include an area not overlapping all the first to third anode electrodes AE1 to AE3 and the cathode electrode CE.

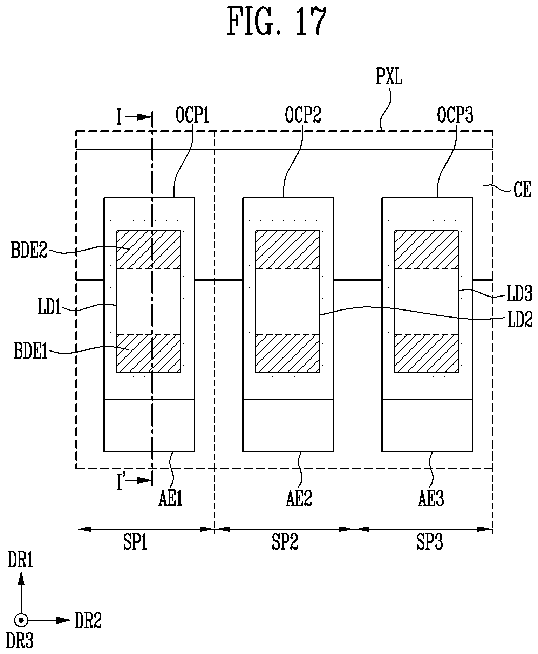

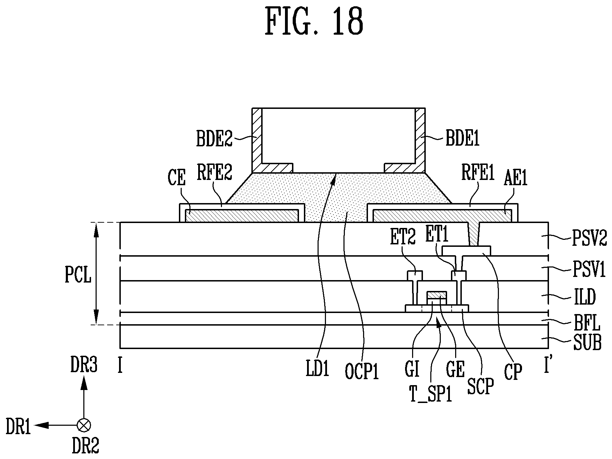

FIG. 17 is a plan view of the display device in S1023 shown in FIG. 12. FIG. 18 is a cross-sectional view taken along line I-I' shown in FIG. 17.

Referring to FIGS. 12, 17, and 18, in S1023 of S1020, the first to third light emitting elements LD1 to LD3 may be formed on the first to third overcoat patterns OCP1 to OCP3.

In some embodiments, the first to third light emitting elements LD1 to LD3 may be disposed on the substrate SUB (or the pixel circuit layer PCL) through various transfer processes. The first to third light emitting elements LD1 to LD3 may be disposed on the first to third overcoat patterns OCP1 to OCP3, respectively. The first to third light emitting elements LD1 to LD3 may overlap the first to third overcoat patterns OCP1 to OCP3, respectively.

Each of the first to third light emitting elements LD1 to LD3 may include first and second element electrodes BDE1 and BDE2. The first and second element electrodes BDE1 and BDE2 may be spaced apart from each other in the first direction DR1. Also, the first and second element electrodes BDE1 and BDE2 may be disposed on side surfaces of each of the first to third light emitting elements LD1 to LD3 to face the third direction DR3. Accordingly, the first and second element electrodes BDE1 and BDE2 may be exposed.

The first and second element electrodes BDE1 and BDE2 of each of the first to third light emitting elements LD1 to LD3 may overlap each of the anode electrodes AE1 to AE3 and the cathode electrode CE, respectively. For example, the first element electrode BDE1 of the first light emitting element LD1 may overlap the first anode electrode AE1. The second element electrode BDE2 of the first light emitting element LD1 may overlap the cathode electrode CE. The first element electrode BDE1 of the second light emitting element LD2 may overlap the second anode electrode AE2. The second element electrode BDE2 of the second light emitting element LD2 may overlap the cathode electrode CE. The first element electrode BDE1 of the third light emitting element LD3 may overlap the third anode electrode AE3. The second element electrode BDE2 of the third light emitting element LD3 may overlap the cathode electrode CE.

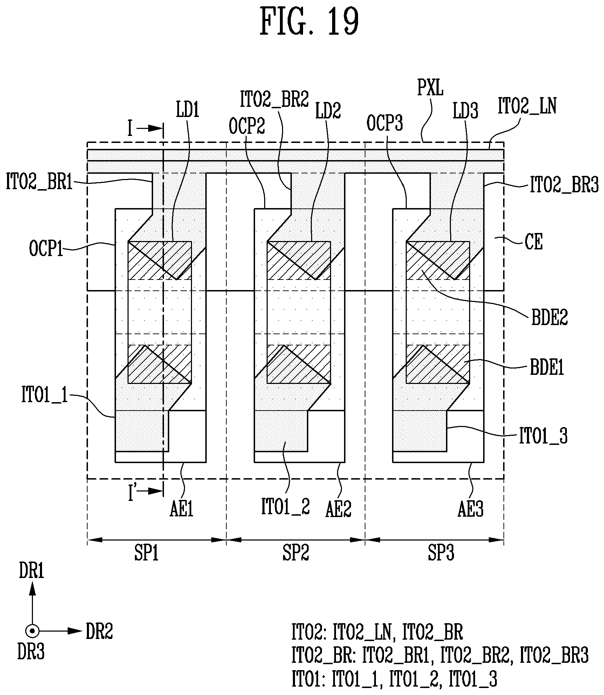

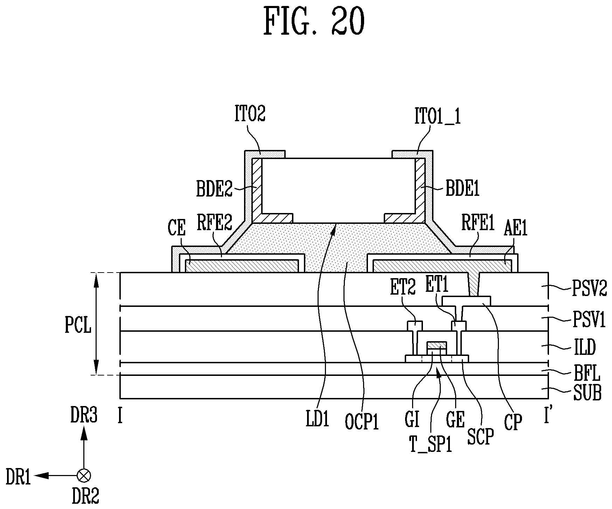

FIG. 19 is a plan view of the display device in S1024 shown in FIG. 12. FIG. 20 is a cross-sectional view taken along line I-I' shown in FIG. 19.

Referring to FIGS. 12, 19, and 20, in S1024 of S1020, the anode transparent electrodes ITO1 and the cathode transparent electrode ITO2 may be formed on the first to third light emitting elements LD1 to LD3.

In some embodiments, the anode transparent electrodes ITO1 may be formed, which overlap the first element electrode BDE1 of each of the first to third light emitting elements LD1 to LD3. For example, a first anode transparent electrode ITO1_1 may overlap a portion of the first element electrode BDE1 of the first light emitting element LD1 on the first anode electrode AE1. A second anode transparent electrode ITO1_2 may overlap a portion of the first element electrode BDE1 of the second light emitting element LD2 on the second anode electrode AE2. A third anode transparent electrode ITO1_3 may overlap a portion of the first element electrode BDE1 of the third light emitting element LD3 on the third anode electrode AE3. However, in a plan view, each of the first to third anode transparent electrodes ITO1_1 to ITO1_3 may overlap about 1/3 or more of an area of a first element electrode BDE1 of a corresponding light emitting element.

The first anode transparent electrode ITO1_1 may be electrically connected to the first element electrode BDE1 of the first light emitting element LD1. The first element electrode BDE1 of the first light emitting element LD1 may be electrically connected to the first anode electrode AE1 through the first anode transparent electrode ITO1_1. The second anode transparent electrode ITO1_2 may be electrically connected to the first element electrode BDE1 of the second light emitting element LD2. The first element electrode BDE1 of the second light emitting element LD2 may be electrically connected to the second anode electrode AE2 through the second anode transparent electrode ITO1_2. The third anode transparent electrode ITO1_3 may be electrically connected to the first element electrode BDE1 of the third light emitting element LD3. The first element electrode BDE1 of the third light emitting element LD3 may be electrically connected to the third anode electrode AE3 through the third anode transparent electrode ITO1_3.

The cathode transparent electrode ITO2 may be formed, which overlaps the second element electrode BDE2 of each of the first to third light emitting elements LD1 to LD3. The cathode transparent electrode ITO2 may include a line electrode ITO2_LN and branch electrodes ITO2_BR. For example, the line electrode ITO2_LN may extend in the second direction DR2, and be disposed throughout the first to third sub-pixels SP1 to SP3. Also, the line electrode ITO2_LN may be disposed while being spaced apart from the first to third overcoat patterns OCP1 to OCP3 in the first direction DR1, not to overlap the first to third overcoat patterns OCP1 to OCP3.

On the other hand, each of the branch electrodes ITO2_BR may extend in the first direction DR1 from the line electrode ITO2_LN to overlap the second element electrode BDE2. For example, a first branch electrode ITO2_BR1 may overlap a portion of the second element electrode BDE2 of the first light emitting element LD1 on the cathode electrode CE. A second branch electrode ITO2_BR2 may overlap a portion of the second element electrode BDE2 of the second light emitting element LD2 on the cathode electrode CE. A third branch electrode ITO2_BR3 may overlap a portion of the second element electrode BDE2 of the third light emitting element LD3 on the cathode electrode CE. However, in a plan view, each of the first to third branch electrodes ITO2_BR1 to ITO2_BR3 may overlap about 1/3 or more of an area of a second element electrode BDE2 of a corresponding light emitting element.

The first branch electrode ITO2_BR1 may be electrically connected to the second element electrode BDE2 of the first light emitting element LD1. The second element electrode BDE2 of the first light emitting element LD1 may be electrically connected to the cathode electrode CE through the first branch electrode ITO2_BR1. The second branch electrode ITO2_BR2 may be electrically connected to the second element electrode BDE2 of the second light emitting element LD2. The second element electrode BDE2 of the second light emitting element LD2 may be electrically connected to the cathode electrode CE through the second branch electrode ITO2_BR2. The third branch electrode ITO2_BR3 may be electrically connected to the second element electrode BDE2 of the third light emitting element LD3. The second element electrode BDE2 of the third light emitting element LD3 may be electrically connected to the cathode electrode CE through the third branch electrode ITO2_BR3.

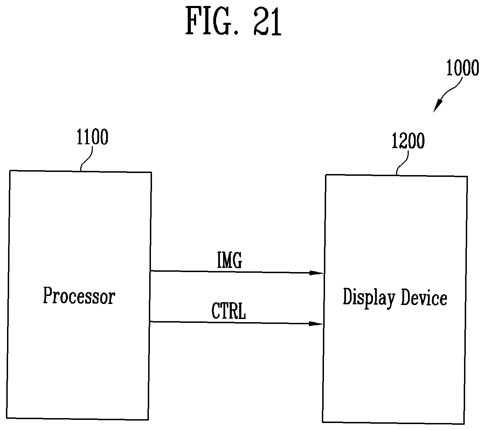

FIG. 21 is a block diagram illustrating an embodiment of a display system.

Referring to FIG. 21, a display system 1000 may include a processor 1100 and a display device 1200.

The processor 1100 may perform various tasks and various calculations. In embodiments, the processor 1100 may include an Application Processor, a Graphics Processing Unit, a microprocessor, a Central Processing Unit (CPU), or the like. The processor 1100 may be connected to other components of the display system 1000 through a bus system to control the components of the display system 1000.

The processor 1100 may transmit image data IMG and a control signal CTRL to the display device 1200. The display device 1200 may display an image, based on the image data IMG and the control signal CTRL. The display device 1200 may be configured similar to the display device DD described with reference to FIG. 1. The image data IMG and the control signal CTRL may be provided as the input image data IMG and the control signal CTRL, which are shown in FIG. 1, respectively.

The display system 1000 may include a computing system for providing an image display function, such as a smart watch, a mobile phone, a smartphone, a portable computer, a tablet personal computer (PC), a watch phone, an automotive display, a smart glass, a portable multimedia player (PMP), a navigation system, or an ultra mobile computer (UMPC). The display system 1000 may include at least one of a head mounted display (HMD) device, a virtual reality (VR) device, a mixed reality (MR) device, and an augmented reality (AR) device.

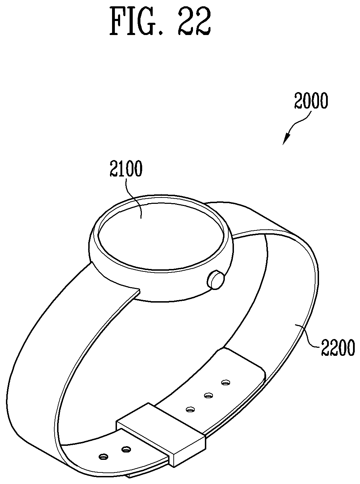

FIGS. 22 to 25 are schematic perspective views illustrating application examples of the display system shown in FIG. 21.

Referring to FIG. 22, the display system 1000 shown in FIG. 21 may be applied to a smart watch 2000 including a display part 2100 and a strap part 2200.

The smart watch 2000 may be a wearable electronic device. For example, the smart watch 2000 may have a structure in which the strap part 2200 is mounted on a wrist of a user. The display system 1000 and/or the display device 1200 may be applied to the display part 2100, so that image data including time information can be provided to the user.

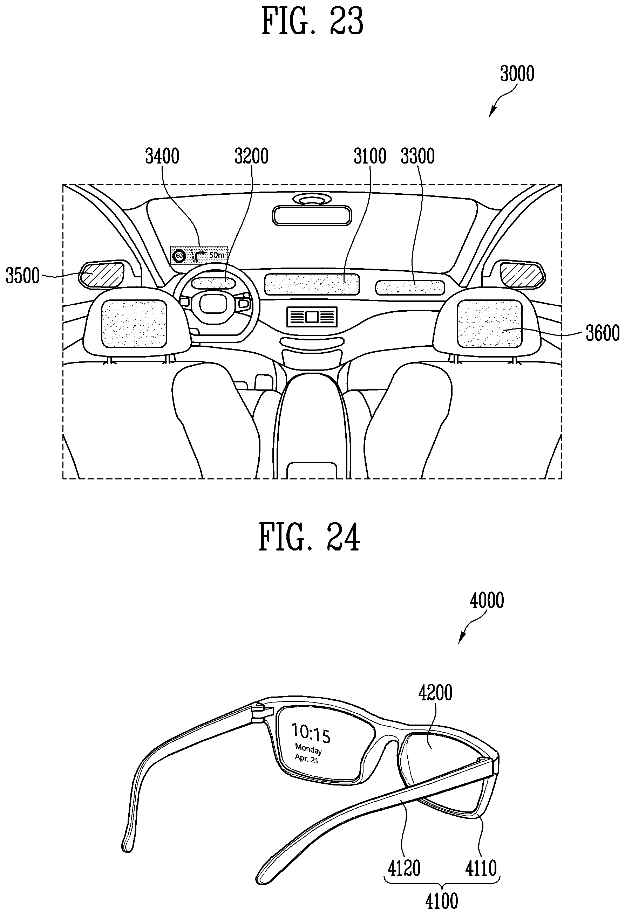

Referring to FIG. 23, the display system 1000 shown in FIG. 21 may be applied to an automotive display system 3000. The automotive display system 3000 may include a computing system provided at the inside/outside of a vehicle to provide image data.

For example, the display system 1000 and/or the display device 1200 may be applied to at least one of an infotainment panel 3100, a cluster 3200, a co-driver display 3300, a head-up display 3400, a side mirror display 3500, and a rear seat display 3600, which are provided in the vehicle.

Referring to FIG. 24, the display system 1000 shown in FIG. 21 may be applied to smart glasses 4000. The smart glasses 4000 are a wearable electronic device which can be worn on the face of a user. For example, the smart glasses 4000 may be a wearable device for Augmented Reality.

The smart glasses 4000 may include a frame 4100 and a lens part 4200. The frame 4100 may include a housing 4110 supporting the lens part 4200 and a leg part 4120 for allowing the user to wear the smart glasses 4000. The leg part 4120 may be connected to the housing 4110 through a hinge, to be folded or unfolded with respect to the housing 4110.

A battery, a touch pad, a microphone, a camera, and the like may be built in the frame 4100. A projector for outputting light, a processor for controlling a light signal, and the like may be built in the frame 4100.

The lens part 4200 may be an optical member which allows light to be transmitted through the optical member or allows light to be reflected by the optical member. For example, the lens part 4200 may include glass, transparent synthetic resin, and the like.

In order to enable eyes of the user to recognize visual information, the lens part 4200 may allow an image caused by a light signal transmitted from the projector of the frame 4100 to be reflected by a rear surface (e.g., a surface in a direction facing the eyes of the user) of the lens part 4200. For example, the user may recognize information including time, data, and the like, which are displayed on the lens part 4200. The projector and/or the lens part 4200 may be a kind of display device. The display device 1200 may be applied to the projector and/or the lens part 4200.

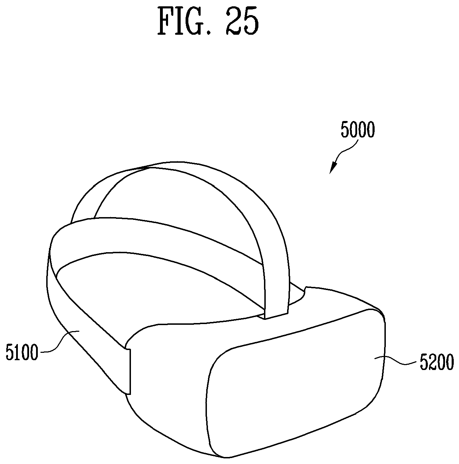

Referring to FIG. 25, the display system 1000 shown in FIG. 21 may be applied to a head mounted display device 500.

The head mounted display device 5000 may be a wearable electronic device which can be worn on the head of a user. For example, the head mounted display device 5000 may be a wearable device for virtual reality or mixed reality.

The head mounted display device 5000 may include a head mounted band 5100 and a display accommodating case 5200. The head mounted band 5100 may be connected to the display accommodating case 5200. The head mounted band 5100 may include a horizontal band and/or a vertical band, used to fix the head mounted display device 5000 to the head of the user. The horizontal band may be configured to surround a side portion of the head of the user, and the vertical band may be configured to surround an upper portion of the head of the user. However, embodiments are not limited thereto. For example, the head mounted band 5100 may be implemented in the form of a glasses frame, a helmet or the like.

The display device accommodating case 5200 may accommodate the display system 1000 and/or the display device 1200.

In the display device in accordance with embodiments of the disclosure, the length of a residue pattern PRP formed along the circumference of each of overcoat patterns OCP can be increased through arrangement design of anode transparent electrodes ITO1 and a cathode transparent electrode ITO2. Accordingly, first and second element electrodes BDE1 and BDE2 can be prevented from being short-circuited with each other by the residue pattern PRP, thereby reducing a failure risk.

Although specific embodiments and applications have been described herein, other embodiments and modifications may be derived from the above description. Accordingly, the scope of the present invention is not limited to these embodiments, but extends to the claims set forth below, various obvious modifications, and equivalents.

## Claims

1. A display device, comprising:
a display element layer disposed on a substrate, the display element layer including:
an anode electrode and a cathode electrode, disposed on the substrate and spaced apart from each other in a first direction;
an overcoat pattern partially covering the anode electrode and the cathode electrode;
a light emitting element disposed on the overcoat pattern, the light emitting element including a first element electrode and a second element electrode, the first element electrode and the second element electrode being adjacent to the anode electrode and the cathode electrode, respectively;
an anode transparent electrode disposed on the overcoat pattern to electrically connect the first element electrode and the anode electrode to each other; and
a cathode transparent electrode disposed on the overcoat pattern to electrically connect the second element electrode and the cathode electrode to each other, wherein
the cathode transparent electrode includes:
a line electrode extending in a second direction intersecting the first direction; and
a branch electrode extending in the first direction from the line electrode,
the first element electrode and the second element electrode are spaced apart from each other at a first distance in the first direction, and
the anode transparent electrode and the branch electrode are spaced apart from each other at a second distance greater than or equal to the first distance in the first direction.

2. The display device of claim 1, wherein
the branch electrode overlaps the overcoat pattern in plan view, and
the line electrode does not overlap the overcoat pattern in plan view.

3. The display device of claim 2, wherein
a circumference of the overcoat pattern includes:
a first edge overlapping the anode transparent electrode in plan view;
a second edge overlapping the branch electrode in plan view;
a third edge extending between the first edge and the second edge; and
a fourth edge extending between the first edge and the second edge, the fourth edge being opposite to the third edge, and
at least one of the third edge and the fourth edge has a length longer than the first distance.

4. The display device of claim 3, wherein the display element layer further includes a residue pattern disposed adjacent to at least one of the third edge and the fourth edge.

5. The display device of claim 4, wherein the residue pattern has a length longer than the first distance.

6. The display device of claim 1, wherein
the overcoat pattern includes a first portion, a second portion, and a third portion, which are sequentially disposed in the second direction,
each of the first to third portions extends in the first direction to overlap the anode electrode and the cathode electrode in plan view, the first portion overlaps the anode transparent electrode in plan view without overlapping the branch electrode in plan view,
the second portion overlaps both the branch electrode and the anode transparent electrode in plan view, and
the third portion overlaps the branch electrode in plan view without overlapping the anode transparent electrode in plan view.

7. The display device of claim 1, wherein
the first element electrode and the second element electrode are spaced apart from each other in the first direction,
the anode transparent electrode overlaps at least a portion of the first element electrode in plan view, and
the cathode transparent electrode overlaps at least a portion of the second element electrode in plan view.

8. The display device of claim 1, wherein the anode transparent electrode overlaps about 1/3 or more of an area of the first element electrode in plan view.

9. The display device of claim 1, wherein
the anode electrode has a first width in the second direction,
the anode transparent electrode has a second width in the second direction, and
the second width is narrower than the first width.

10. The display device of claim 1, wherein
the anode transparent electrode includes a first portion and a second portion,
the first portion extends in the first direction, and
the second portion extends in a diagonal direction intersecting the first and second directions from the first portion to overlap at least a portion of the first element electrode.

11. The display device of claim 1, wherein the cathode transparent electrode overlaps about 1/3 or more of an area of the second element electrode in plan view.

12. The display device of claim 1, wherein the line electrode is spaced apart from the overcoat pattern in the first direction.

13. The display device of claim 1, wherein
the branch electrode includes a first portion and a second portion,
the first portion extends in the first direction, and
the second portion extends in a diagonal direction intersecting the first and second directions from the first portion to overlap at least a portion of the second element electrode.

14. The display device of claim 1, wherein
the anode transparent electrode and the cathode transparent electrode are disposed in a same layer, and
the anode transparent electrode and the cathode transparent electrode include a same transparent conductive material.

15. A display device, comprising:
a display element layer disposed on a substrate, the display element layer including:
anode electrodes disposed on the substrate;
a cathode electrode disposed on the substrate, the cathode electrode being spaced apart from the anode electrodes in a first direction;
overcoat patterns partially covering the anode electrodes and the cathode electrode;
light emitting elements disposed on the overcoat patterns, the light emitting elements each including a first element electrode and a second element electrode;
anode transparent electrodes disposed on the overcoat patterns to electrically connect the first element electrodes of the light emitting elements to the anode electrodes; and
a cathode transparent electrode disposed on the overcoat patterns to electrically connect the second element electrodes of the light emitting elements to the cathode electrode, wherein
the cathode transparent electrode includes:
a line electrode extending in a second direction intersecting the first direction; and
branch electrodes extending in the first direction from the line electrode,
the first element electrode and the second element electrode of any one of the light emitting elements are spaced apart from each other at a first distance in the first direction, and
any one of the anode transparent electrodes and any one of the branch electrodes are spaced apart from each other at a second distance greater than or equal to the first distance in the first direction.

16. The display device of claim 15, wherein
the light emitting elements include a first light emitting element and a second light emitting element,
the anode electrodes include a first anode electrode and a second anode electrode,
the anode transparent electrodes include a first anode transparent electrode electrically connecting the first element electrode of the first light emitting element to the first anode electrode and a second anode transparent electrode electrically connecting the first element electrode of the second light emitting element to the second anode electrode,
the first anode transparent electrode and the second anode transparent electrode are spaced apart from each other at a third distance in the second direction, and
the first anode electrode and the second anode electrode are spaced apart from each other at a fourth distance smaller than the third distance in the second direction.

17. The display device of claim 16, wherein
each of the first element electrodes of the first and second light emitting elements has a first width in the second direction, and
the third distance is smaller than or equal to a sum of about a half of the first width and the fourth distance.

18. The display device of claim 15, wherein
the branch electrodes overlap the overcoat patterns in plan view, and
the line electrode does not overlap the overcoat patterns in plan view.

19. The display device of claim 18, wherein
a circumference of any one of the overcoat patterns includes:
a first edge overlapping a corresponding one of the anode transparent electrodes in plan view;
a second edge overlapping a corresponding one of the branch electrodes in plan view;
a third edge extending between the first edge and the second edge; and
a fourth edge extending between the first edge and the second edge, the fourth edge being opposite to the third edge, and
at least one of the third edge and the fourth edge has a length longer than the first distance.

20. The display device of claim 19, wherein the display element layer further includes a residue pattern disposed adjacent to at least one of the third edge and the fourth edge of the any one of the overcoat patterns.
